(19) **Europäisches Patentamt**
**European Patent Office**
**Office européen des brevets**

(11) **EP 3 399 323 B1**

(12) **FASCICULE DE BREVET EUROPEEN**

(45) Date de publication et mention
de la délivrance du brevet:
**27.04.2022 Bulletin 2022/17**

(21) Numéro de dépôt: **18169845.7**

(22) Date de dépôt: **27.04.2018**

(51) Classification Internationale des Brevets (IPC):
**G01R 31/26** (2020.01)    **G01R 31/12** (2020.01)
**H01L 21/66** (2006.01)

(52) Classification Coopérative des Brevets (CPC):
**G01R 31/2621; G01R 31/129; H01L 22/14**

(54) **PROCÉDÉ DE CARACTÉRISATION ÉLECTRIQUE DE TRANSISTOR MOS SUR SOI**

ELEKTRISCHES CHARAKTERISIERUNGSVERFAHREN EINES MOS-TRANSISTORS AUF EINEM
SOI-SCHALTKREIS

METHOD FOR ELECTRICALLY CHARACTERISING A SOI-MOS TRANSISTOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **02.05.2017 FR 1753839**

(43) Date de publication de la demande:
**07.11.2018 Bulletin 2018/45**

(73) Titulaire: **Commissariat à l'Energie Atomique et
aux Energies
Alternatives
75015 Paris (FR)**

(72) Inventeurs:
• **LEROUX, Charles
38360 NOYAREY (FR)**
• **MOHAMAD, Blend
22036 Erba (IT)**

(74) Mandataire: **Cabinet Camus Lebkiri
25 rue de Maubeuge
75009 Paris (FR)**

(56) Documents cités:
**EP-A1- 2 290 386    DE-A1-102006 057 419
GB-A- 2 351 156    US-B1- 8 004 290**

• **MOHAMAD B ET AL: "Reliable gate stack and
substrate parameter extraction based on C-V
measurements for 14nm node FDSOI
technology", SOLID STATE ELECTRONICS, vol.
128, 15 octobre 2016 (2016-10-15), pages 10-16,
XP029861961, ISSN: 0038-1101, DOI:
10.1016/J.SSE.2016.10.010**
• **ISABELLE FERAIN ET AL: "Methodology for
Flatband Voltage Measurement in Fully Depleted
Floating-Body FinFETs", IEEE TRANSACTIONS
ON ELECTRON DEVICES, IEEE SERVICE
CENTER, PISACATAWAY, NJ, US, vol. 55, no. 7,
1 juillet 2008 (2008-07-01), pages 1657-1663,
XP011216585, ISSN: 0018-9383**
• **KWONG D-L ET AL: "Thermally Robust HfN Metal
as a Promising Gate Electrode for Advanced MOS
Device Applications", IEEE TRANSACTIONS ON
ELECTRON DEVICES, IEEE SERVICE CENTER,
PISACATAWAY, NJ, US, vol. 51, no. 4, 1 avril 2004
(2004-04-01), pages 609-615, XP011109439, ISSN:
0018-9383, DOI: 10.1109/TED.2004.825110**
• **HOU Y T ET AL: "Metal Gate Work Function
Engineering on Gate Leakage of MOSFETs", IEEE
TRANSACTIONS ON ELECTRON DEVICES, IEEE
SERVICE CENTER, PISACATAWAY, NJ, US, vol.
51, no. 11, 1 novembre 2004 (2004-11-01), pages
1783-1789, XP011121194, ISSN: 0018-9383, DOI:
10.1109/TED.2004.836544**
• **LEROUX ET AL: "Accurate determination of flat
band voltage in advanced MOS structure",
MICROELECTRONICS AND RELIABILITY,
ELSEVIER SCIENCE LTD, GB, vol. 47, no. 4-5, 21
avril 2007 (2007-04-21), pages 660-664,
XP022042384, ISSN: 0026-2714, DOI:
10.1016/J.MICROREL.2007.01.033**

Il est rappelé que: Dans un délai de neuf mois à compter de la publication de la mention de la délivrance du brevet
européen au Bulletin européen des brevets, toute personne peut faire opposition à ce brevet auprès de l'Office européen
des brevets, conformément au règlement d'exécution. L'opposition n'est réputée formée qu'après le paiement de la taxe
d'opposition. (Art. 99(1) Convention sur le brevet européen).

**Description**

## DOMAINE DE L'INVENTION

La présente invention se situe dans le domaine de la caractérisation électrique des transistors formés par un empilement de type métal/oxyde/semiconducteur ou MOS. Un objet de la présente invention est un procédé de mesure d'un jeu de paramètres d'un transistor de type MOS sur substrat de type SOI (Silicon on Insulator). Selon un aspect de l'invention ledit jeu de paramètres comprend la tension de bandes plates à la face arrière de l'oxyde enterré. Selon un autre aspect de l'invention ledit jeu de paramètres comprend l'épaisseur équivalente d'oxyde EOT (« Equivalent Oxide Thickness » en anglais) ainsi que le travail de sortie du métal de grille avant Weff.

## ETAT DE L'ART

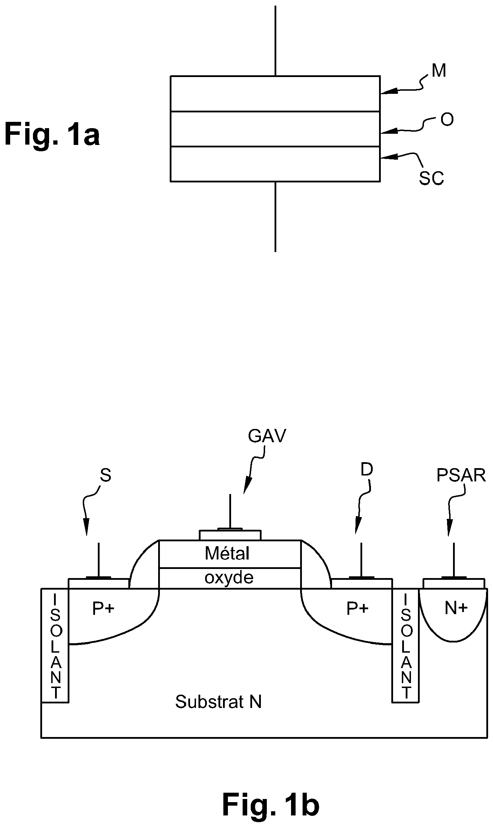

Les industries de la microélectronique engagées dans le développement de filières CMOS (« Complementary Metal Oxide Semiconductor » en anglais) ont besoin d'outils efficaces pour comparer des technologies variées ayant des architectures spécifiques. La figure 1a montre un empilement MOS formé par un métal M, un oxyde O et un semi-conducteur S. La figure 1b montre un transistor obtenu à partir d'un empilement MOS sur substrat massif sur silicium. La figure 1b montre notamment les électrodes de source S et drain D, la grille face avant GAV et la prise substrat face arrière PSAR. Deux paramètres souvent utilisés dans la caractérisation des transistors MOS sont la tension de seuil Vth du transistor et l'épaisseur équivalente de capacité à tension donnée CET. Toutefois, il reste difficile de comparer deux assemblages différents sur la base de ces deux paramètres car la CET est couplée à Vth. Ce dernier dépend aussi du substrat, voire de sa polarisation. Une comparaison de transistors MOS sur SOI mais aussi sur bulk fabriqués avec des procédés différents à partir de paramètres tels que la CET et Vth est considérée peu fiable.

Une approche alternative consiste à prendre en compte deux autres paramètres, à savoir l'épaisseur d'oxyde équivalent EOT et le travail de sortie effectif du métal de grille Weff. Ces deux paramètres sont définis comme étant respectivement l'épaisseur de l'oxyde et le travail de sortie effectif du métal de grille d'un empilement MOS idéal ayant le même comportement électrique que le dispositif que l'on caractérise. Cet empilement MOS idéal de référence est constitué d'un métal, d'un diélectrique en oxyde de silicium ayant une constante diélectrique connue de $3,9*8,85*10^{-12}$ F/m et d'un substrat semi-conducteur. L'oxyde de silicium de cet empilement MOS est considéré comme parfait, sans charges et sans dipôles à ses interfaces.

Les deux paramètres EOT et Weff définissent donc un langage commun pour comparer deux technologies différentes. Par exemple, une comparaison à partir de EOT et Weff permet de mettre en évidence des phénomènes de croissance de diélectrique ou de décalage électrique des polarisations de référence, tels que la présence de charges dans les diélectriques, de dipôles aux interfaces ou de modifications du travail de sortie du métal de grille.

L'EOT et le Weff sont donc des paramètres fondamentaux pour les technologues qui leur permettent de suivre de manière pertinente le procédé de l'empilement MOS et d'ajuster les performances du transistor MOS. Ces deux paramètres permettent de suivre directement l'épaisseur du diélectrique et le travail de sortie équivalent de la grille qui est posée dessus. Il s'agit donc de deux bras de levier essentiels pour un technologue pour ajuster les performances du transistor MOS. Ils sont couramment suivis dans les études de technologies des procédés (« process Technology »).

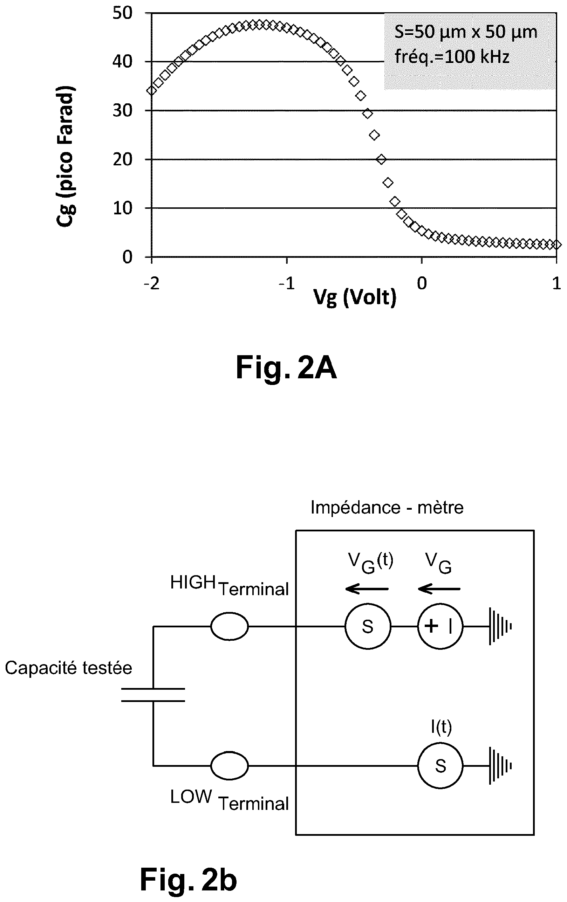

L'EOT et le Weff peuvent être extraits à partir d'une mesure expérimentale de la capacité du dispositif que l'on veut caractériser en fonction de la tension appliquée au métal de grille ou caractéristique C(V). Une telle mesure peut être réalisée en utilisant le montage expérimental de la figure 2b.

Pour une caractéristique C(V) expérimentale telle que celle montrée à la figure 2a, extraire l'EOT et Weff revient donc à trouver respectivement l'épaisseur de diélectrique et le travail de sortie du métal de l'empilement MOS idéal qui a le même comportement électrique que le dispositif que l'on caractérise.

Dans le cas d'un empilement MOS sur substrat massif, une caractéristique C(V) donnée est univoquement déterminée à partir d'un ensemble de trois paramètres formé par l'EOT, le dopage du substrat et la tension de bandes plates Vfb. Ce dernier paramètre est la tension appliquée sur la grille respectivement au substrat et aux source et drain pour laquelle la charge dans le semi-conducteur est nulle. Le paramètre Weff est ensuite calculé à partir de l'ensemble de trois paramètres identifié grâce à la mesure de C(V), essentiellement le dopage et la tension de bandes plates.

Traditionnellement les paramètres EOT et Weff sont obtenus à partir d'une analyse directe de cette caractéristique C(V) et en faisant des calculs à partir de plusieurs points de cette courbe expérimentale, souvent les capacités maximum et minimum. Ces méthodes sont listées dans « Accurate détermination of flat band voltage in advanced MOS structures » de C. Leroux et al. publié dans Microelectronics Reliability 47, 2007 pages 660-664.

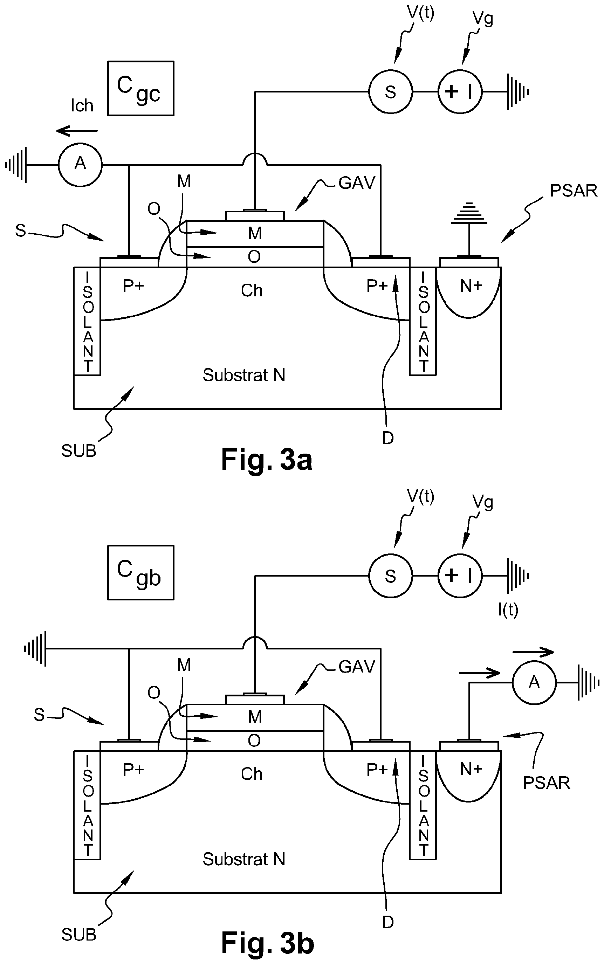

La figure 2a montre un exemple de caractéristique C(V) obtenue pour un empilement MOS déposé sur un substrat massif tel que celui illustré aux figures 1a et 1b. La courbe de la figure 2a est obtenue de façon connue avec le montage expérimental montré en figure 2b. Ce montage comprend un impédance-mètre dont les terminaux sont branchés sur la capacité à déterminer. Les figures 3a et 3b illustrent les deux types de capacités qui peuvent être mesurées avec le montage de la figure 2b. Il s'agît de la capacité Cgc, entre grille face avant GAV et canal Ch, illustrée à la figure 3a et de la capacité Cgb entre la grille face avant GAV et la prise substrat face arrière PSAR, illustrée à la figure 3b. Dans les deux cas une tension continue Vg et une tension alternative v(t) sont appliquées à la grille face avant GAV.

La courbe expérimentale illustrée à la figure 2a est la capacité entre grille et substrat Cgb de figure 3b. Cette mesure est réalisée pour un empilement MOS sur substrat massif de type P.

Les méthodes analytiques permettant d'extraire les paramètres Weff et EOT sont décrites par exemple dans l'article « Accurate détermination of flat band voltage in advanced MOS structures » de C. Leroux et al. publié dans Microelectronics Reliability 47 (2007) pages 660-664.

La diminution des dimensions, en particulier l'épaisseur des oxydes, et l'utilisation de nouveaux semi-conducteurs a nécessité de prendre en compte les effets quantiques et les structures de bande propres à ces semi-conducteurs. Dès lors, pour une caractéristique capacité tension C(V) expérimentale les paramètres d'EOT et Weff ont été extraits en recherchant la simulation numérique d'un empilement MOS idéal qui s'ajuste à l'expérience.

Néanmoins, cette méthode peut s'avérer fastidieuse car elle nécessite pour chaque technologie et chaque mesure une simulation numérique qui en soit représentative puis des essais sur EOT et Weff pour obtenir un bon ajustement entre les deux caractéristiques expérimentales et simulées.

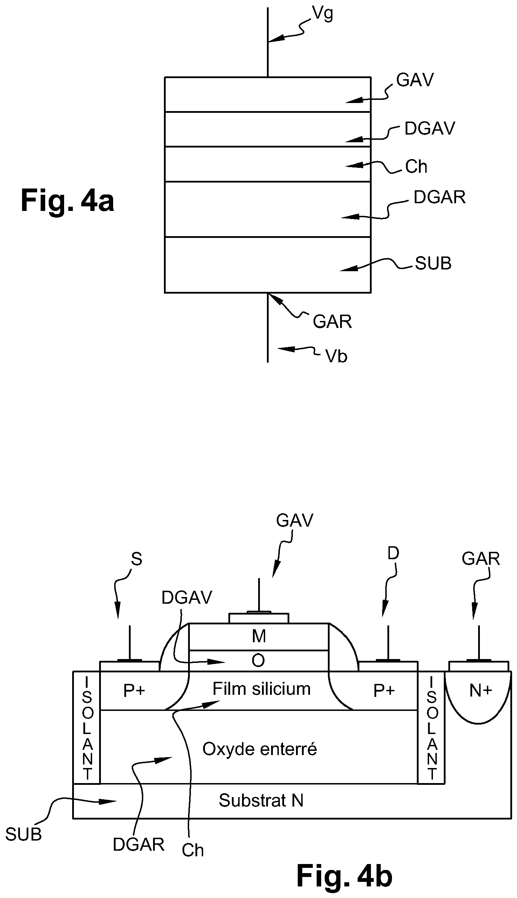

Mais bien plus, les méthodes connues rencontrent plusieurs difficultés sérieuses dans le cas des empilements MOS sur substrat SOI tel que l'empilement illustré aux figures 4a et 4b.

L'empilement MOS sur SOI illustré à la figure 4a est formé par un métal constituant la grille face avant GAV, un oxyde ou diélectrique de grille face avant DGAV, une couche de semi-conducteur formant le canal Ch, un deuxième oxyde ou diélectrique de grille face arrière DGAR et un substrat semi-conducteur SUB. La tension appliquée à la grille face avant est appelée polarisation de grille face avant PGAV ou tension de grille Vg et la tension appliquée à la grille face arrière est appelée polarisation de grille face arrière PGAR ou tension de grille face arrière Vb.

Le transistor MOS sur SOI de la figure 4b est obtenu à partir d'un empilement du type illustré à la figure 4a.

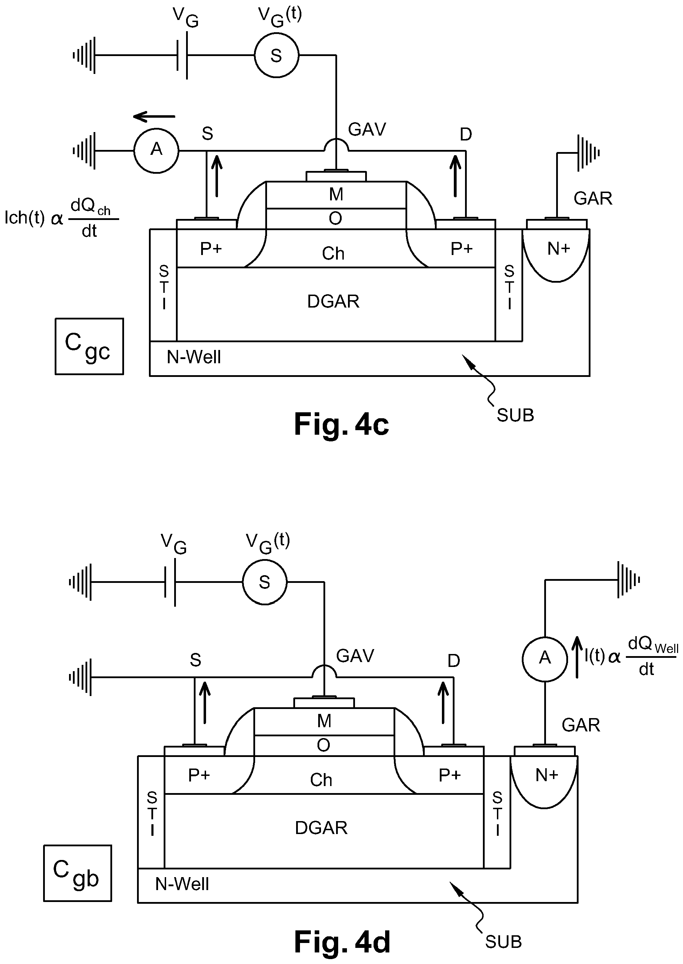

Les figures 4c et 4d montrent les montages expérimentaux pour mesurer Cgc et Cgb dans le cas d'un empilement MOS sur SOI.

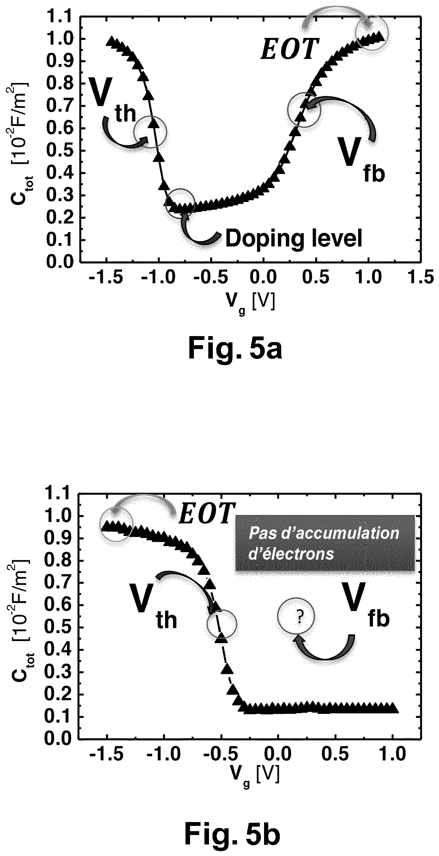

Tout d'abord la caractéristique C(V) relative à un empilement MOS sur SOI montre une variation avec la tension réduite par rapport à la même mesure relative à un empilement MOS sur substrat massif. En effet, si la caractéristique bulk donnait des signaux dans les trois régimes d'accumulation, de déplétion et d'inversion, la caractéristique SOI ne donne accès qu'à la partie inversion de canal. Ceci est par exemple illustré à la figure 5a qui montre une caractéristique C(V) pour un empilement MOS, à comparer avec la figure 5b qui montre une caractéristique C(V) pour un empilement MOS sur SOI. Cette différence empêche dans le cas de l'empilement MOS sur SOI de déterminer les trois paramètres Vfb, Weff et EOT à partir de l'étude de points spécifiques de la caractéristique C(V), puisque la tension de bandes plates n'est plus accessible car se trouvant dans une gamme de polarisation pour laquelle le signal de capacitif n'est pas représentatif.

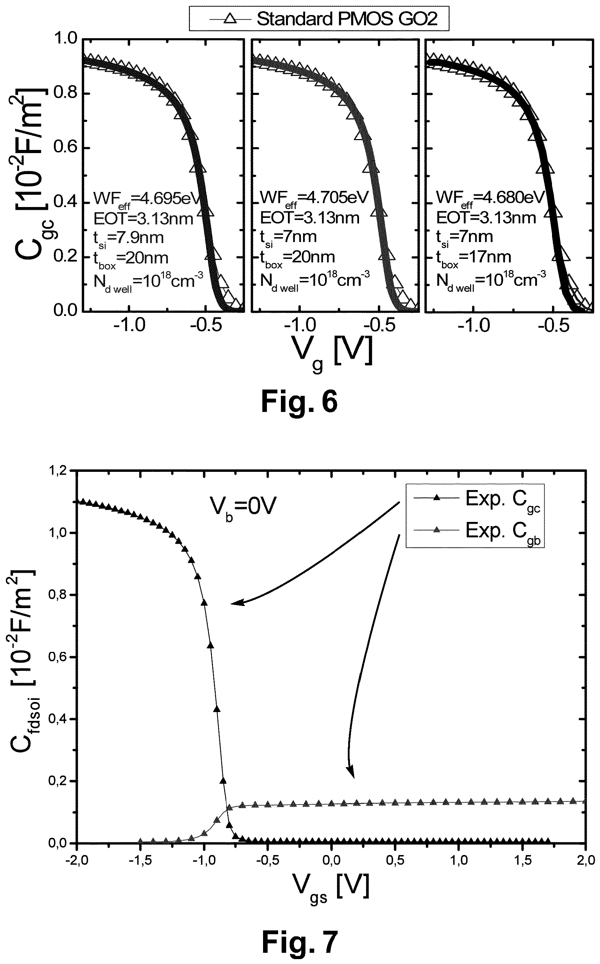

Par ailleurs, la méthode de l'ajustement de la caractéristique Cgc(Vg) avec un modèle théorique ne donne pas non plus des résultats très satisfaisants. Par exemple, la figure 6 (issue du document « Reliable Gate Stack and Substrate Parameter Extraction based on C-V measurements for 14 nm node FDSOI technology » de M. Mohamad et al.) montre qu'à partir d'une même caractéristique C(V) il est possible d'obtenir plusieurs jeux de paramètres lors de l'ajustement entre la mesure et le modèle. Il est notamment possible d'obtenir plusieurs valeurs de travail de sortie Weff selon les valeurs que l'on suppose pour des paramètres spécifiques d'un empilement MOS sur SOI.

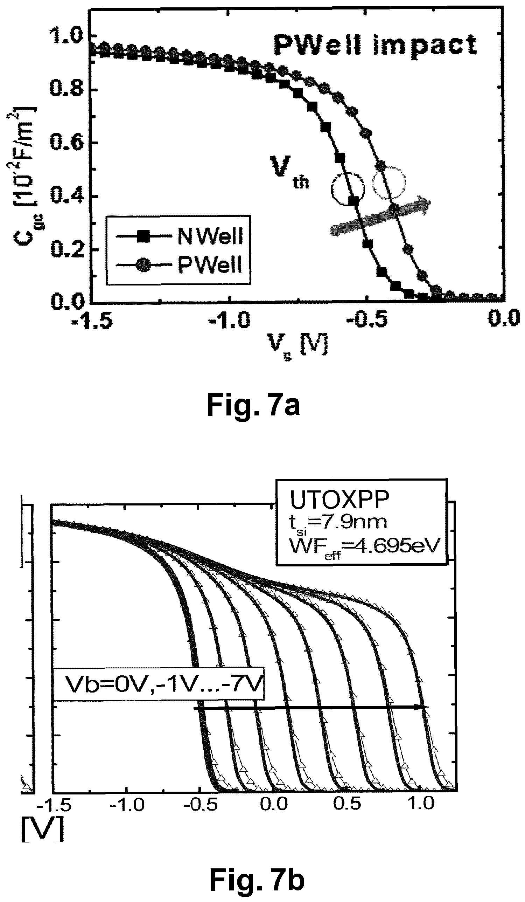

Non seulement l'identification d'un jeu de paramètres unique décrivant la structure MOS sur SOI n'est pas possible par la simulation, mais la mesure elle-même semble ne pas être unique pour un même empilement de grille. On rapporte en figure 7a pour un même empilement technologique (grille métal GAV, diélectrique DGAV, film semi-conducteur Ch, oxyde enterré DGAR), les différentes caractéristiques que l'on obtient selon le substrat SUB qui se trouve en face arrière de l'oxyde enterrée, ou en figure 7b selon la polarisation de grille Vb de ce substrat SUB. On voit qu'il est possible de décaler de manière sensible de plusieurs centaines de millivolts les caractéristiques C(V). L'extraction des paramètres EOT et Weff à partir de la seule capacité Cgc(Vg) rencontrent donc de sérieux obstacles sur substrat SOI.

Autrement dit, une mesure sur substrat SOI sur la base d'une seule caractéristique Cgc(Vg) et sans tenir compte de son contexte de mesure (épaisseur de canal Ch, épaisseur d'oxyde enterré DGAR, nature du substrat SUB à la face arrière et sa polarisation,...) conduit à une mesure de Weff qui peut être erronée ou peu reproductible.

Les méthodes connues pour l'extraction des paramètres EOT et Weff à partir de la caractéristique C(V) mesurée ne sont pas précises et fiables dans le cas d'un empilement MOS sur substrat SOI, ce qui rend ces mesures peu adaptées pour devenir des outils d'analyse statistique des transistors lors de leur production.

## RESUME DE L'INVENTION

L'invention vise à résoudre ces problèmes grâce à un procédé permettant l'extraction de façon fiable et reproductible des paramètres Weff et EOT pour un empilement MOS sur substrat SOI. Le procédé selon l'invention permet en outre de déterminer la tension de bandes plates à la face arrière de l'oxyde enterré, ce qui n'est pas possible avec les méthodes connues de l'homme du métier.

Un premier objet de l'invention est un procédé de mesure d'un jeu de paramètres d'un transistor de type MOS sur substrat de type SOI (Silicon On Insulator), ledit jeu de paramètres incluant au moins la tension de bandes plates Vfb à la face arrière de l'oxyde enterré, ledit procédé comprenant les étapes suivantes :

- appliquer à la face arrière du substrat du transistor une tension principale continue Vbs et une tension alternative v(t), la tension principale continue Vbs pouvant balayer une plage de valeurs prédéterminée ;
- mesurer le courant électrique Ig(t) issu de la grille face avant et déterminer à partir de cette mesure la capacité Cbg entre la face arrière du substrat du transistor et la grille face avant, de façon à obtenir la caractéristique Cbg(Vbs) ;
- à partir de la caractéristique Cbg(Vbs) déterminer la caractéristique Cbg(Vgb), Vgb étant la tension entre la grille face avant et la grille face arrière ;
- déterminer le jeu de paramètres en réalisant un ajustement entre la caractéristique Cbg(Vgb) et un modèle théorique décrivant le comportement d'un transistor de type MOS sur substrat massif, ledit ajustement étant limité à la plage de valeurs de Vgb pour lesquels le canal du transistor est en régime de déplétion.

On entend par un transistor de type MOS (Métal/Oxyde/Semi-conducteur) sur substrat SOI (Silicon on Insulator) un transistor MOS dans lequel la couche de semi-conducteur ou canal semi-conducteur Ch du MOS est formée sur une couche diélectrique telle qu'une couche d'oxyde. Cette couche diélectrique est appelée également diélectrique de grille arrière DGAR.

Le diélectrique de grille arrière DGAR supportant le canal semi-conducteur Ch du MOS est située au-dessus d'une couche de semi-conducteur appelée substrat SUB du transistor MOS sur SOI. Pour cette raison le diélectrique de grille arrière DGAR est également appelé oxyde enterré.

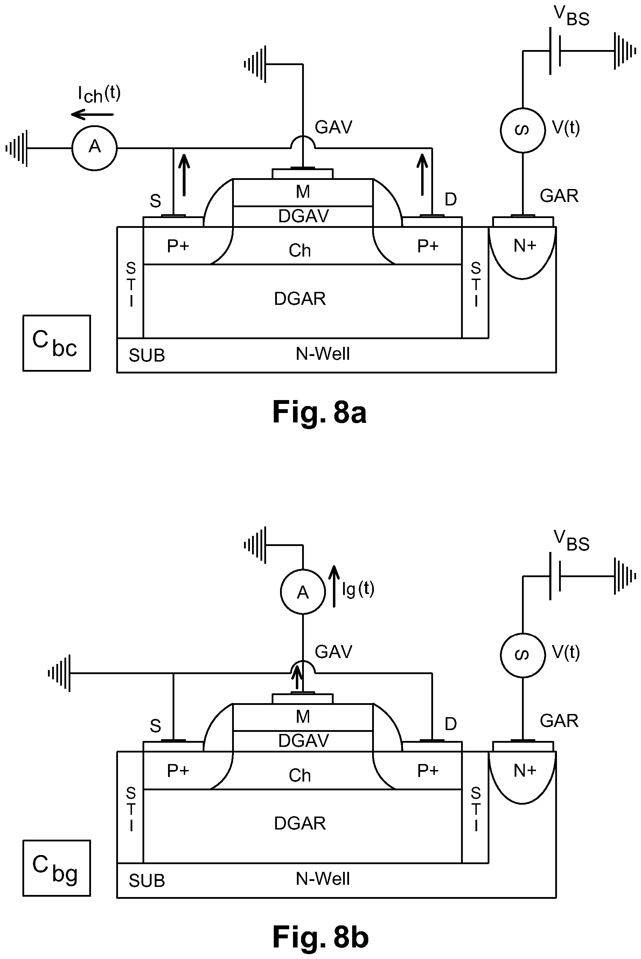

La structure d'un transistor de type MOS sur SOI est illustrée aux figures 4a, 4b, 8a et 8b. La figure 8b montre le montage expérimental pour la mise en œuvre du procédé selon l'invention.

La structure d'un transistor de type MOS sur substrat massif est illustrée aux figures 1a et 1b.

On entend par face arrière du substrat du transistor la surface externe du substrat SUB semi-conducteur. Une électrode est appliquée sur cette surface externe pour l'application des tensions Vbs et v(t). La superposition de Vbs et v(t) est également appelée stimulus.

On entend par grille face avant GAV couche métallique M de l'empilement MOS.

On entend par grille face arrière GAR l'électrode appliquée sur la face arrière du substrat SUB d'un empilement MOS sur SOI.

On entend par tension de bandes plates Vfb à la face arrière de l'oxyde enterrée DGAR la tension Vbs appliquée à la face arrière GAR du substrat semi-conducteur SUB pour laquelle la charge dans le substrat semi-conducteur SUB est nulle.

On entend par modèle théorique décrivant le comportement d'un transistor de type MOS sur substrat massif un modèle pour le calcul de la caractéristique Cgb(Vgb) dans le cas d'un transistor MOS sur substrat massif.

La mesure du courant Ig(t) issu de la grille face avant GAV permet de déterminer à l'aide d'un impédance-mètre la capacité Cbg, à savoir la capacité entre la face arrière du substrat GAR et la grille face avant GAV.

Pour comprendre le principe de l'invention, nous allons d'abord expliquer en détail pourquoi des mesures d'une caractéristique C(V) réalisées avec un montage standard tel que celui des figures 4c et 4d ne permettent pas de déterminer de façon simple les paramètres d'intérêt. Autrement dit, le procédé selon l'invention permet de simplifier la détermination de paramètres tels que la tension de bandes plates, l'EOT et le Weff dans le cas d'un empilement MOS sur SOI.

Les figures 4c et 4d montrent que deux capacités différentes peuvent être mesurées avec le montage de figure 2b : la capacité Cgb entre grille face avant GAV et semi-conducteur massif ou bulk, et la capacité Cgc entre grille face avant GAV et canal Ch.

Dans les deux cas, on utilise l'impédance-mètre de la figure 2b. Cet appareil permet de superposer sur l'un de ses terminaux une tension petit signal vg(t) alternative à une tension principale Vg continue. Cette tension est connectée à la grille face avant GAV des figures 4c et 4d.

Dans le cas de la figure 4c, le deuxième terminal de l'impédance-mètre est connecté aux électrodes source S et drain D du transistor MOS. Il est donc possible de mesurer le courant Ich(t) collecté par source S et/ou drain D et remonter à la caractéristique Cgc(Vg).

Dans le cas de la figure 4d, le deuxième terminal de l'impédance-mètre est connecté à la face arrière GAR du substrat semi-conducteur et il est possible de remonter à la caractéristique Cgb(Vg).

Les deux capacités Cgc et Cgb étant en parallèle, il est possible de réaliser les deux montages de figure 4c et 4d en même temps pour mesurer la capacité totale Ct(Vg), Ct étant la somme de Cgc et Cgb.

Nous considérons d'abord le cas d'un transistor du type MOS sur substrat massif comme celui montré à la figure 3a et à la figure 3b. On considère ici un substrat de type N, dans lequel les porteurs majoritaires sont les électrons.

Un empilement MOS comprend deux capacités en série : la capacité diélectrique Cox et la capacité du semi-conducteur Csc. Si on connaît la relation entre la charge dans le semi-conducteur Qsc et la chute de potentiel interne à ses bornes $\psi_{SC}$, on peut calculer Csc = dQsc/d$\psi_{SC}$. La capacité totale du système peut alors être calculée :

$$1/\, C_g(Q_{sc}) = 1/C_{ox} + 1/C_{sc}(Q_{sc}) \quad (1)$$

Quand on augmente la tension Vg pour un semi-conducteur de type P (respectivement N), le substrat SUB passe successivement d'une accumulation de trous (respectivement inversion de trous) à une déplétion puis une inversion d'électron (respectivement accumulation d'électrons). Il y a donc un moment où la charge du substrat SUB est nulle. Du point de vue de la simulation, cela veut dire Qsc =0 ou, dit autrement, une situation de bandes d'énergie plates à l'interface semi-conducteur/diélectrique. Cette tension est la tension de bandes plates Vfb. La charge dans les électrodes pour n'importe quelle autre tension peut donc se calculer par intégration de la capacité du système à partir de cette tension dite de bandes plates:

$$Q_{SC}(V_g) = -Q_g(V_g) = -\int_{Vfb}^{Vg} Cg.\, dV \quad (2)$$

La capacité Cg de l'équation (2) est la capacité totale Ctot. Toutefois si on travaille en accumulation/déplétion la capacité Cgb est suffisante.

En outre la chute de tension Vg correspond, aux travaux de sortie près, à la chute de tension dans le diélectrique Vox plus celle dans le semi-conducteur $\psi_{SC}$. Ce qui conduit à l'équation 3 :

$$V_g = W_{F,M}/q - W_{F,S}/q + \Psi_{sc} + V_{ox} \qquad (3)$$

*q étant la charge de l'électron*

Cette expression s'explicite en tenant compte de la relation entre la charge aux électrodes et la chute de tension dans le diélectrique Vox =- Qsc/Cox. $W_{F,M}$ et $W_{F,S}$ sont des données des matériaux de chacune des électrodes, leur travail de sortie. Ainsi pour un semi-conducteur dopé à un niveau Nsc, on peut calculer $W_{F,S}$ pour la température ambiante ( T=300°K) avec $W_{F,S}$ = 4,61 eV +L. k.T. In (Nsc /ni) avec ni dopage intrinsèque du silicium, couramment ni= 1010 /cm3 à 300°K et k constante de Boltzmann 1,38.10-23 J/°K, avec L valant +1 pour un substrat P et -1 pour un substrat N, on arrive alors à :

$$Vg(Qsc) = W_{F,M}/q - W_{F,S}/q + \psi_{sc}(Qsc) - Qsc/Cox \quad (4)$$

On a, par ailleurs, défini Vfb comme la tension de grille pour laquelle la charge dans le semi-conducteur est nulle, il s'ensuit :

$$V_g(Qsc) = Vfb + \psi_{sc}(Qsc) - \psi_{sc}(Vfb) - Q_{sc}/Cox \qquad (5)$$

Weff étant le travail de sortie d'une grille idéale rendant compte de la même caractéristique, il s'ensuit:

$$Weff/q = Vfb - \psi_{sc}(Vfb) + W_{F,S}/q \quad (6)$$

Ce qui amène à réécrire l'équation 5 en :

$$Vg(Qsc) = Weff/q - W_{F,S}/q + \psi_{sc}(Qsc) - Qsc/Cox \quad (7)$$

Les équations 1, 2 et 4 nous permettent donc de définir de manière unique une caractéristique C(V) pour un empilement dont on a précisé les paramètres caractéristiques : le type de métal ($W_{F,M}$), l'épaisseur du diélectrique (son

épaisseur $T_{ox}$ ou l'EOT) et le type de semi-conducteur (son travail de sortie $W_{F,S}$ et sa relation entre charge et potentiel : $\psi_{SC}$ (Qsc)). Si on utilise Vfb plutôt que $W_{F,S}$, Vfb, EOT et $\psi_{SC}$ (Qsc) définissent alors de manière unique la caractéristique C(V) à partir des équations 1,2 et 5. Toutefois, on notera que ces équations sont liées entre elles de manière complexe et qu'il n'est plus possible d'extraire EOT et Vfb de manière indépendante comme ce pouvait être le cas avec les méthodes analytiques.

La figure 4a montre un empilement MOS sur SOI et la figure 4b montre un transistor de type MOS sur SOI. Dans le cas des dispositifs MOS sur SOI, la tension Vfb ne peut plus être identifiée directement par la mesure. En effet, comme il est visible sur les figures 5a et 5b, les caractéristiques C(V) mesurées dans les deux cas apparaissent différentes.

Dans le cas d'un transistor MOS sur substrat massif, la figure 5a montre que pour des tensions de grille Vg différentes la capacité varie, ce qui reflète une variation de charge dans le substrat semi-conducteur SUB. En particulier pour des tensions de grilles Vg négatives le substrat SUB est en inversion de trous. A l'augmenter de la tension de grille Vg les électrons dans le substrat SUB augmentent jusqu'à l'obtention d'une accumulation d'électrons. En allant de l'inversion de trous à l'accumulation d'électrons, le substrat SUB passe forcément par une condition de charge nulle. Autrement dit, la remontée de la capacité pour des tensions de grille Vg positives permet d'identifier la condition de bandes plates Vfb.

La situation de la figure 5b est différente. En effet dans le cas d'un empilement MOS sur SOI on n'observe pas de remontée de la capacité aux tensions Vg positives et la tension Vfb ne peut plus être identifiée par la mesure puisque l'on accède plus qu'à la partie inversion de la capacité. Autrement dit, on n'observe plus la remontée de Cgb due à la formation de porteurs majoritaires dans le substrat SUB. Cette différence s'explique par le fait que nous ne disposons pas de diffusion permettant de « lire » la réponse des porteurs majoritaires à l'interface du diélectrique, l'oxyde enterré DGAR se trouvant entre la prise du substrat SUB et la surface du canal Ch, comme il est illustré à la figure 4b.

L'impossibilité d'accéder à Vfb dans le cas d'un empilement MOS sur SOI rend les techniques usuelles de détermination des paramètres Weff et EOT à partir de la caractéristique C(V) particulièrement complexes et parfois peu fiables.

Par exemple, comme il est visible sur la figure 6, il est possible de trouver plusieurs travaux de sortie selon les valeurs que l'on suppose pour des paramètres spécifiques d'un empilement MOS sur SOI : l'épaisseur du film semi-conducteur Ch et de l'oxyde enterré DGAR.

La présente invention propose donc une nouvelle méthode pour la détermination fiable de paramètres tels que Weff et EOT dans le cas d'un empilement MOS sur SOI.

A défaut d'accéder à la réponse des porteurs majoritaires dans le canal Ch pour identifier la condition de bandes plates, le principe de l'invention repose sur la mise en œuvre de mesures qui permettent de connaitre la charge dans le substrat SUB en dessous de l'oxyde enterré DGAR de la structure SOI. Cela permet de bien connaitre l'état global de polarisation du dispositif sur substrat SOI au moins dans les conditions d'inversion de porteurs ou de déplétion du canal Ch.

Si la mesure de la charge d'inversion du canal Ch est bien connue de l'homme de l'art et correspond à l'intégrale de la capacité Cgc, la mesure de la charge du substrat SUB n'est pas courante en MOS sur SOI et il n'existe pas de moyen immédiat pour y accéder.

Rappelons que, sur la base de l'équation (2), la charge dans un semi-conducteur est calculée à partir de l'intégrale de la capacité. Pour effectuer ce calcul il est nécessaire de connaître la condition de bandes plates qui correspond à une charge nulle. A la différence de la mesure de Cgb sur substrat massif qui connait toute une variation d'amplitude permettant d'identifier la condition de bandes plates et donc d'identifier la charge en fonction de la polarisation, la mesure de Cgb sur SOI rencontre au moins deux difficultés. Visiblement, cette capacité est d'abord nulle puis après son apparition au seuil d'extinction de la capacité Cgc, elle est ensuite quasi constante dans sa plus grande partie. Ceci est illustré à la figure 7 qui montre les contributions de Cgb et Cgc à la capacité totale mesurée pour un MOS sur SOI. Là où Cgb est nulle, la charge dans le substrat SUB n'est pas nécessairement nulle, mais la capacité Cgb devient nulle car c'est la réponse des porteurs du canal Ch, visible sur la capacité Cgc, qui masque l'influence électrostatique dans le substrat des fluctuations appliquées depuis la grille face avant GAV. On peut donc résumer en disant que quand Cgc devient nulle cela correspond bien à une annulation de la charge de porteurs libres et que Cgc(Vgs) permet donc d'identifier la charge de canal en fonction de la polarisation Vgs. Par contre la mesure de Cgb manque de référence car l'annulation de Cgb ne signifie pas que la charge de substrat SUB s'annule, mais qu'elle ne varie plus. On manque donc sur cette caractéristique d'une tension de référence pour laquelle la charge de substrat SUB serait nulle et à partir de laquelle on peut calculer une intégrale du type de l'équation (2) pour le calcul de la charge de substrat.

Le principe de l'invention consiste à identifier une mesure adaptée de la charge dans le substrat SUB. Alors que la mesure courante de capacité se fait en appliquant un stimulus sur la grille face avant GAV et à lire le courant induit sur source S et drain D ou sur la face arrière GAR, comme il est montré aux figures 3a, 3b, 4c et 4d, le procédé selon l'invention repose sur l'application du stimulus sur la face arrière GAR. On pourra donc lire le courant sur source S et drain D ou sur la grille face avant GAV. Les figures 8a et 8b montrent les montages expérimentaux relatifs à ces deux mesures, respectivement Cbc et Cbg.

On obtient alors deux autres mesures différentes qui caractérisent l'empilement MOS constitué par la face arrière GAR comme grille, le même canal Ch relié aux sources S et drain D et la polarisation à une tension de référence Vg de la grille face avant GAV.

La première étape du procédé selon l'invention permet donc d'obtenir ces deux mesures. Plus précisément le stimulus appliqué sur la face arrière du transistor est constitué par la superposition d'une tension principale continue Vbs et une tension alternative v(t). La tension principale continue Vbs peut balayer une plage de valeurs prédéterminée.

Cette mesure conduit à deux nouvelles capacités que l'on nomme Cbc (respectivement Cbg) pour le couplage entre la face arrière GAR et le canal Ch (respectivement le couplage entre la face arrière GAR et la grille face avant GAV).

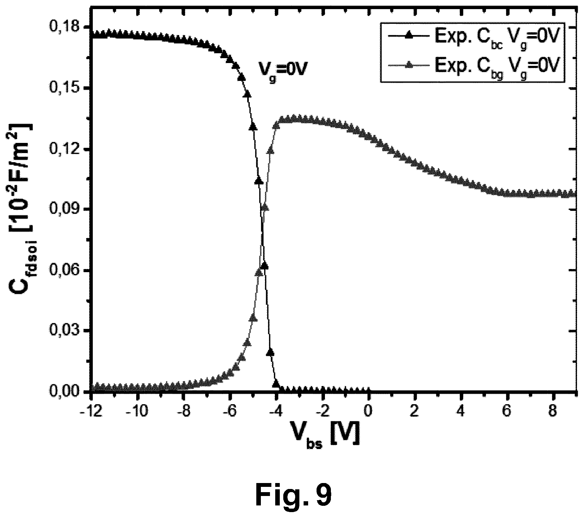

On notera cette fois que la capacité Cbg qui correspond à la mesure et qui retient notre attention connait sur la plage de tension Vbs une variation significative, comme il est illustré à la figure 9. Cette variation significative va permettre cette fois d'accéder plus facilement à la tension de bandes plates Vfb à la face arrière de l'oxyde enterré DGAR.

La deuxième étape du procédé consiste à déterminer Cbg à partir du courant Ig(t) mesuré sur l'électrode de grille face avant. Cette étape du procédé permet donc d'obtenir la caractéristique Cbg(Vbs).

La figure 9 montre que, pour une tension aux environs de -6 à -4 Volts, Cbg s'éteint alors que Cgc devient significatif. Comme expliqué précédemment, cela ne signifie pas que la charge dans la grille GAV s'annule mais qu'elle ne change plus avec la polarisation Vbs, car le canal Ch quittant le régime de déplétion pour passer en inversion de trous masque alors le couplage entre la face arrière GAR et la grille face avant GAV. Nous en concluons donc que la mesure Cbg reflètera bien le couplage entre grille face avant GAV et le substrat SUB seulement si le canal Ch est déplété. Cette remarque est un élément fondamental dans l'invention. Outre les mesures proposées, l'analyse doit prendre en compte cette particularité. Du point de vue de la physique, ceci se produit quand le niveau de Fermi du canal Ch se situe à l'intérieur des bandes du semi-conducteur.

Avantageusement, la variation de Vbs lors de la première étape du procédé permet de mesurer Cbg dans différentes conditions de charge, y compris la condition de déplétion du canal Ch. La condition de déplétion du canal Ch est nécessaire pour éviter que les charges dans le canal masquent la réponse due à la capacité Cbg.

La troisième étape du procédé consiste à transformer la caractéristique Cbg(Vbs) en la caractéristique Cbg(Vgb). Vgb est la chute de potentiel entre la grille face avant GAV et la face arrière GAR du substrat semi-conducteur SUB. Autrement dit, Vgb peut être calculée comme Vgb = Vgc + Vcb avec Vcb = -Vbs.

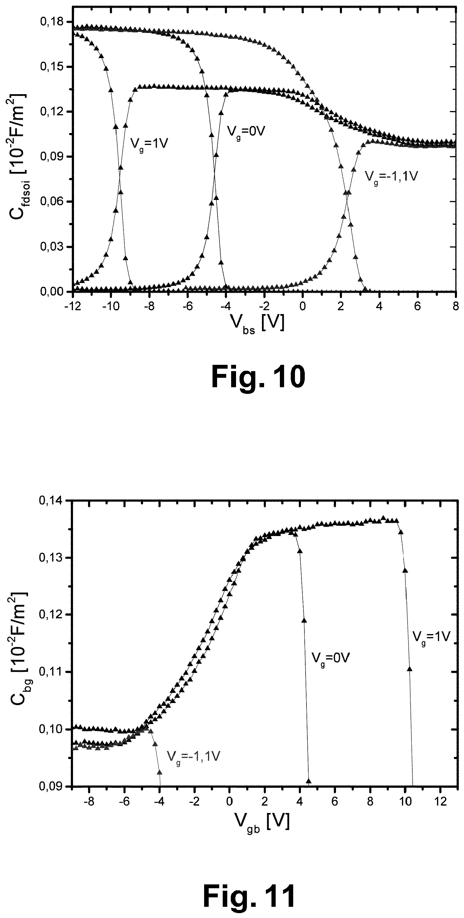

Cette étape permet d'obtenir une caractéristique Cbg(Vgb) qui reflète directement le couplage entre la grille face avant GAV et la grille face arrière GAR. De plus, comme il est visible sur la figure 11, la caractéristique Cbg(Vgb) reconstitue une courbe C(V) typique d'un empilement MOS sur substrat massif.

La zone où la caractéristique Cbg(Vgb) reproduit la caractéristique C(V) d'un MOS sur substrat massif correspond à la condition de déplétion du canal semi-conducteur Ch. Cette plage significative est donc délimitée d'un côté par l'amorce de l'inversion des trous qui cause une chute abrupte de Cbg aux tensions Vgb positives et d'un autre côté par l'amorce à une tension Vgb plus négative de la formation d'une accumulation d'électrons dans le canal Ch.

La valeur de cette plage de tension est donnée en première approximation par $Eg(Tbox + T_{ch,equiv} + Tox)/(Tch,equiv + Tox)$, où Eg est l'énergie de gap du semi-conducteur et $T_{box}$, $T_{ch,equiv}$, $T_{ox}$ sont respectivement les épaisseurs de l'oxyde enterré DGAR, du canal Ch en épaisseur équivalente d'oxyde de silicium et de l'oxyde de grille ou diélectrique de grille avant DGAV. On a $T_{ch,equiv} = T_{ch} \cdot (\varepsilon_{SiO2}/\varepsilon_{ch})$.

Avantageusement, cette étape du procédé permet d'extraire une caractéristique Cbg(Vgb) qui est celle d'un empilement MOS sur substrat massif où :

- la grille face avant GAV est toujours la grille GAV de la capacité étudiée ;
- l'oxyde correspond à l'empilement de trois couches diélectriques qui sont respectivement l'oxyde de grille face avant DGAV, le canal Ch déplété et qui se comporte comme un diélectrique et l'oxyde enterré DGAR ;
- le semi-conducteur est le substrat SUB à la face arrière de l'oxyde enterré.

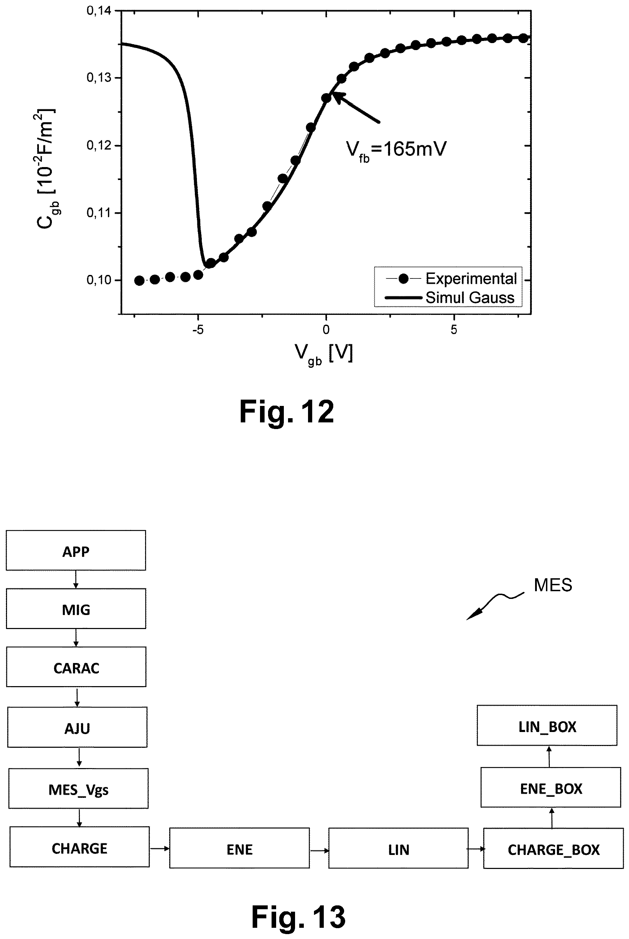

La figure 12 illustre l'étape d'ajustement entre la caractéristique Cgb(Vgb) et un modèle théorique pour la caractéristique C(V) d'un empilement MOS sur substrat massif.

Cette étape permet d'extraire les paramètres de l'empilement MOS équivalent. Cet ajustement doit nécessairement se faire en retenant pour la caractéristique C(V) la plage de valeurs de tension Vbs appliquée pour laquelle le canal Ch est en régime de déplétion, de sorte à ne pas masquer la réponse des porteurs dans le substrat SUB.

Par exemple le modèle théorique utilisé pour l'empilement MOS est une simulation qui prend en compte les propriétés quantiques de l'empilement.

Par exemple les paramètres extraits peuvent être la tension de bandes plates Vfb à la face arrière de l'oxyde enterré DGAR, le travail de sortie de l'électrode de grille face avant Weff et l'épaisseur d'oxyde équivalent EOT.

Dans l'exemple de figure 12 les paramètres obtenus sont Vfb = 0.165 V, Weff = 4.47 eV et $EOT = T_{box} + T_{ch,equiv} + T_{ox} = 24.8$ nm.

Le procédé de mesure selon l'invention permet donc une extraction de Weff et de EOT = $T_{box}$ + $T_{ch,equiv}$ + $T_{ox}$ grâce au fait que les mesures sur MOS sur SOI sont ramenées au comportement d'un MOS sur substrat massif.

Le procédé selon l'invention peut également comporter une ou plusieurs des caractéristiques suivantes selon toutes les combinaisons techniquement possibles :

- le jeu de paramètres PAR comprend, en plus de la tension de bandes plates Vfb à la face arrière de l'oxyde enterré, au moins l'un des paramètres suivants :

  - l'épaisseur équivalente d'oxyde EOT ;

  - le travail de sortie effectif du métal de grille Weff ;

- l'épaisseur équivalent d'oxyde (EOT) correspond à l'épaisseur cumulée des couches d'oxyde, de canal et d'oxyde enterré.

- la caractéristique Cbg(Vbg) est reconstruite à partir de plusieurs mesures de Cbg, chaque mesure étant obtenue pour une tension de grille face avant Vg différente.

- le procédé selon l'invention comprend en outre les étapes suivantes :

  - à partir d'une mesure de type C(Vgs) déterminer les caractéristiques Cgc(Vgs) et Cgb(Vgs), Vgs étant la tension appliquée entre la grille face avant GAV et les électrodes source S et drain D du transistor MOS sur substrat SOI ;

  - à partir de la valeur de la tension de bandes plates Vfb déterminée à l'étape d'ajustement et des caractéristiques Cgb(Vgs) et Cgc(Vgs), calculer la densité surfacique de porteurs N(Qtot) en fonction de la tension Vgs ;

  - à partir de la densité surfacique de porteurs N(Qtot), déterminer l'énergie E, définie par la relation E= qVgs + X + (Ec-Ef), en fonction du nombre de porteurs Ntot, q étant la charge de l'électron, X l'affinité électronique du semiconducteur du canal, Ef le niveau de Fermi du semi-conducteur de canal, Ec l'énergie de la bande de conduction du semi-conducteur du canal à son interface avec l'oxyde de grille face avant DGAV;

  - obtenir à l'aide d'un ajustement linéaire de E en fonction du nombre de porteurs le travail de sortie effectif Weff de la grille avant et l'épaisseur EOTfox effectif de l'oxyde de grille face avant DGAV ;

- le travail effectif de sortie Weff est l'ordonnée à l'origine de la fonction E(Ntot) et l'épaisseur effective de l'oxyde de grille avant EOTfox est obtenue à partir de la pente de la fonction E(Ntot) ;

- le procédé selon l'invention comprend en outre une étape de détermination de l'épaisseur de l'oxyde enterré ;

- Le procédé selon l'invention comprend en outre les étapes suivantes :

  - à partir de la valeur de la tension de bandes plates Vfb déterminée à l'étape d'ajustement et des caractéristiques Cbc(Vbs) et Cbg(Vbs), calculer la densité surfacique de porteurs N(Qtot) en fonction de la tension Vbs ;

  - à partir de la densité surfacique de porteurs N(Qtot) déterminée à l'étape précédente, déterminer l'énergie Eb, définie par la relation Eb= qVbs + X1 + (Ec1-Ef1)(Qtot) - (Ec2-Ef2) (-Qtot), en fonction du nombre de porteurs Ntot, q étant la charge de l'électron, X1 l'affinité électronique du canal semi-conducteur Ch, Ef1 le niveau de Fermi du semiconducteur du canal connecté par source et drain, Ec1 l'énergie de la bande de conduction du semi-conducteur du canal Ch à l'interface canal Ch/oxyde enterré DGAR, Ef2 le niveau de Fermi du semiconducteur du substrat SUB connecté par la prise GAR, Ec2 l'énergie de la bande de conduction du semi-conducteur du substrat SUB à l'interface arrière de l'oxyde enterré;

  - obtenir à l'aide d'un ajustement linéaire de Eb en fonction du nombre de porteurs l'affinité électrique du substrat semi-conducteur X2 et l'épaisseur EOTbox effectif de l'oxyde enterré DGAR.

- Le procédé comprend en outre une étape de calcul de l'épaisseur efficace du canal semi-conducteur EOTSi, l'épaisseur efficace du canal semi-conducteur étant calculé comme EOTSi = EOT - EOTOX -EOTBox.

## LISTE DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- La figure 1a montre un schéma d'un empilement MOS, métal/oxyde/semi-conducteur ;
- La figure 1b montre un exemple de transistor MOS obtenu à partir de l'empilement de la figure 1a et ayant un substrat de type N ;
- La figure 2a montre la capacité mesurée entre grille face avant GAV et la face arrière GAR du substrat semi-conducteur pour un transistor du type montré en figure 1b, le substrat étant de type P ;
- La figure 2b montre un montage pour la mesure de la capacité de figure 2a à l'aide d'un impédence-mètre ;
- La figure 3a montre en détail le montage pour la mesure de la capacité Cgc entre grille face avant GAV et canal Ch à l'aide de l'impédance-mètre de figure 2b, dans le cas d'un transistor MOS sur substrat massif ;
- La figure 3b montre en détail le montage pour la mesure de la capacité Cgb entre grille face avant GAV et prise substrat face arrière PSAR à l'aide de l'impédance-mètre de figure 2b, dans le cas d'un transistor MOS sur substrat massif ;
- La figure 4a montre un schéma d'un empilement MOS, métal/oxyde/semi-conducteur, sur SOI, silicon on insulator ;
- La figure 4b montre un transistor MOS sur SOI ;
- La figure 4c montre le montage expérimental pour la mesure de la capacité Cgc dans le cas d'un MOS sur SOI ;
- La figure 4d montre le montage expérimental pour la mesure de la capacité Cgb dans le cas d'un MOS sur SOI ;
- La figure 5a montre la caractéristique C(Vg) pour un transistor MOS sur substrat massif, le transistor ayant un substrat de type N et des diffusions source et drain de type P, Vg étant la tension de grille face avant ;
- La figure 5b montre une caractéristique C(Vg) pour un transistor MOS sur SOI ayant des diffusions source et Drain de type P, Vg étant la tension de grille face avant GAV;
- La figure 6 montre différents ajustements d'une caractéristique Cgc pour un transistor MOS sur SOI ;
- La figure 7 montre les capacités Cgc et Cgb obtenues pour un MOS sur substrat SOI ; ces mesures sont obtenues avec les montages des figures 4c et 4d ;
- Les figures 7a et 7b montrent différentes caractéristiques Cgc(Vg) obtenues pour un même empilement metal/oxyde/semi-conducteur sur SOI et différentes polarisation Vb de grille face arrière GAR ou différents types de dopage de substrat face arrière ;
- La figure 8a montre le montage selon l'invention pour la mesure de la capacité Cbc entre face arrière GAR du substrat SUB et canal Ch ;
- La figure 8b montre le montage selon l'invention pour la mesure de la capacité Cbg entre face arrière GAR du substrat SUB et grille face avant GAV;
- La figure 9 montre les capacités Cbc(Vbs) et Cbg(Vbs) obtenues en utilisant les montages des figures 8a et 8b, Vbs étant la tension appliquée à la face arrière GAR du substrat SUB du transistor MOS sur SOI ;
- La figure 10 montre les capacités Cbc et Cbg mesurées avec le montage des figures 8a et 8b, les mesures de figure 10 étant obtenues pour des valeurs différentes de la tension Vg de grille avant GAV ;
- La figure 11 montre les capacités Cbg de la figure 10 tracées cette fois en fonction de Vgb = Vgc - Vbs, ou Cbg(Vgb) ;
- La figure 12 montre l'ajustement entre la capacité Cbg(Vgb) et un modèle théorique pour un transistor MOS sur substrat massif ;
- La figure 13 montre un schéma des étapes du procédé selon l'invention ;

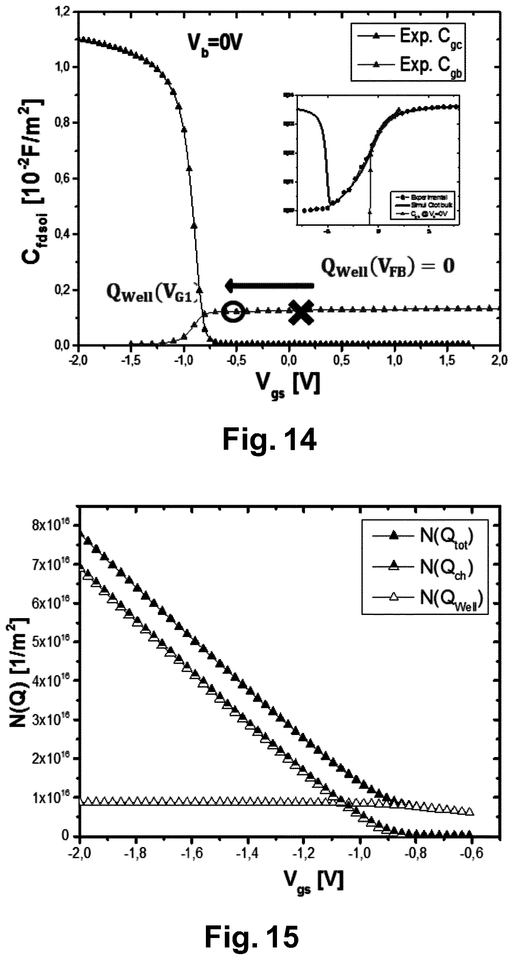

- La figure 14 montre comment, grâce à l'ajustement de la figure 12, on peut identifier la tension de bandes plates Vfb à la face arrière de l'oxyde enterré DGAR pour les mesures de la figure 7 ;
- La figure 15 montre les différentes densités surfaciques de charge obtenue à partir des mesures des figures 14 et 12 ;

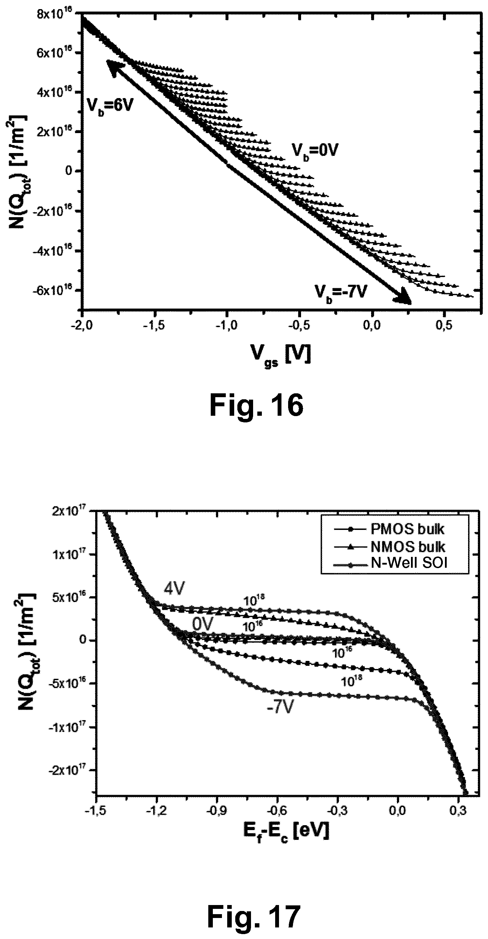

- La figure 16 montre les courbes de densité surfacique totale de la figure 15 pour différentes valeurs de polarisation Vb de grille face arrière GAR ;
- La figure 17 montre des simulations de la densité surfacique de charge totale en fonction de la différence Ec-Ef pour différents transistors MOS sur substrat massif et MOS sur SOI ;

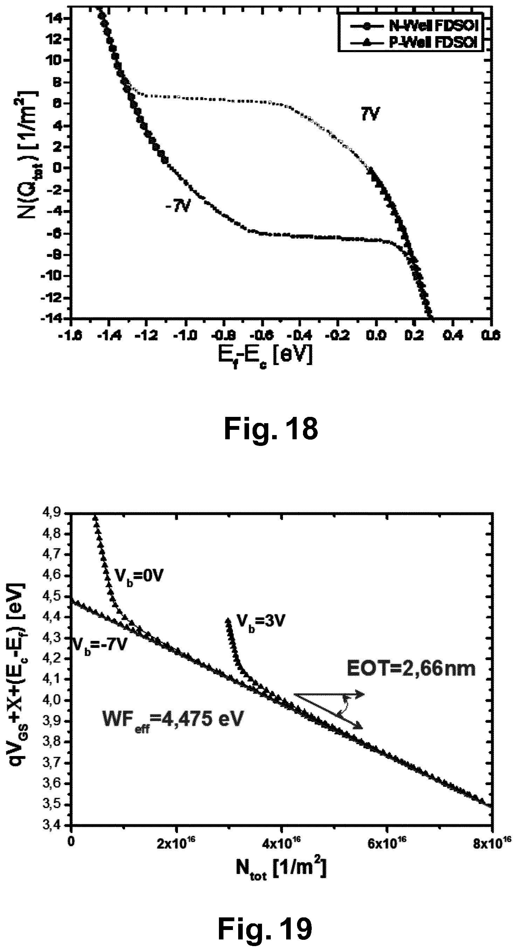

- La figure 18 montre la relation universelle N(Qtot) = f(Ec-Ef) pour un substrat Silicium en régime d'accumulation ou d'inversion de porteurs libres ;
- La figure 19 montre l'énergie E = qVgs + X + (Ec-Ef), obtenue grâce aux courbes des figures 18 et 16, en fonction de la densité totale de porteurs Ntot ;

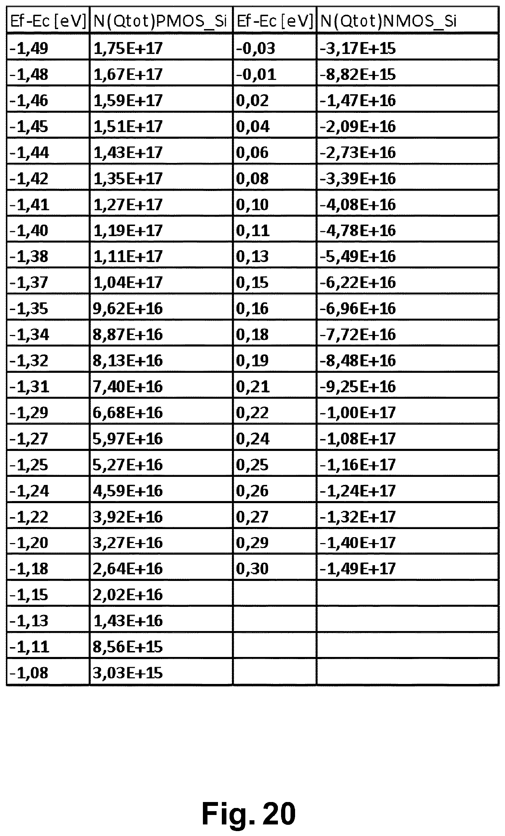

- La figure 20 représente les valeurs des courbes de la figure 18 sous forme de tableau.

## DESCRIPTION DETAILLEE

La figure 13 montre un schéma des étapes du procédé MES de mesure d'un jeu de paramètres PAR d'un transistor de type MOS sur SOI.

Le jeu de paramètres déterminé comprend au moins la tension de bande plates Vfb à la face arrière de l'oxyde enterré DGAR.

Selon un mode de réalisation, le jeu de paramètres ainsi déterminé comprend également des paramètres tels que l'épaisseur d'oxyde équivalent EOT et le travail de sortie effectif Weff du métal de la grille face avant GAV.

La première étape APP comprend l'application d'un stimulus à la face arrière GAR du substrat SUB du transistor MOS sur SOI. Ce stimulus est formé par une tension principale continue Vbs et une tension alternative v(t).

La tension principale Vbs peut balayer une plage de tensions DV.

La deuxième étape MIG du procédé comprend la mesure du courant Ig(t) issu de la grille face GAV avant du transistor MOS sur SOI. La deuxième étape MIG comprend également la mesure, à partir de la mesure du courant Ig, de la capacité Cbg entre la face arrière GAR du substrat SUB du transistor et la grille face avant GAV, de façon à obtenir la caractéristique Cbg(Vbs).

La première étape APP et la deuxième étape MIG du procédé MES selon l'invention peuvent être réalisées grâce au montage illustré à la figure 8b. Sur la figure 8b on peut voir que la tension Vbs et la tension v(t) sont appliquées à la face arrière GAR du substrat semi-conducteur SUB.

Avantageusement, la superposition d'une tension continue Vbs et d'une tension alternative v(t) permet de mesurer la capacité entre la grille face avant GAV et la face arrière GAR du substrat SUB du semi-conducteur. La mesure de la capacité peut être réalisée en analysant le courant Ig(t) à l'aide d'un impédance-mètre comme il est montré à la figure 2b.

La figure 9 montre un exemple de caractéristique Cbg(Vbs) mesurée grâce aux étapes APP et MIG du procédé MES selon l'invention. La figure 9 montre également la caractéristique Cbc(Vbs)

Grâce au montage illustré à la figure 8a, il est possible de mesurer la capacité Cbc entre face arrière GAR du substrat SUB et canal Ch du transistor MOS sur SOI. La capacité Cbc est obtenue en mettant en œuvre le procédé MES selon l'invention.

Les deux caractéristiques Cbg et Cbc étant connectées en parallèle, il est possible de mesurer la capacité totale du dispositif Ct = Cbc + Cbg en même temps, avec les montages des figures 8a, 8b et 2b.

La figure 9 montre un exemple de caractéristique Cbg(Vbs) obtenue grâce aux étapes APP et MIG selon l'invention.

LA figure 9 montre également une caractéristique Cbc(Vbs) obtenue grâce aux mêmes étapes du procédé MES selon l'invention.

Selon un mode de réalisation, les étapes APP et MIG peuvent être répétées pour différentes valeurs de tension Vg appliquées à la grille face avant GAV. Par exemple, les trois couples de caractéristiques montrées à la figure 10 représentent les caractéristiques Cbg et Cbc pour trois valeurs différentes de Vg, la tension appliquée à l'électrode de grille. Les valeurs de Vg sont respectivement -1 V, 0 V et 1V. La tension Vg n'est pas représentée sur les figures 8a et 8b.

Avantageusement, la mesure des caractéristiques Cbg et Cbc pour différentes valeurs de Vg permet d'élargir la plage de valeurs de Vbs sur laquelle on observe une variation des valeurs des capacités et permet d'obtenir une extraction plus précise de la tension de bandes plates Vfb à la face arrière de l'oxyde enterré DGAR.

Le procédé de mesure MES selon l'invention comprend en outre une étape de détermination CARAC de la caractéristique Cbg(Vgb), Vgb étant la chute de potentiel entre grille face avant GAV et face arrière GAR du substrat SUB.

Avantageusement, la caractéristique Cbg(Vgb) permet de rendre compte du couplage entre grille face avant GAV et grille face arrière GAR.

Cette étape correspond à un changement de variable, car Vgb peut être exprimée comme Vgb = Vgc + Vcb, avec Vcb = - Vbs, comme il est visible sur la figure 8b.

Le résultat de cette étape CARAC d'obtention de la caractéristique Cbg(Vgb) à partir de la caractéristique Cbg(Vbs) est représenté à la figure 11. Les trois courbes de figure 11 sont obtenues pour les trois valeurs de tension de grille face avant Vg de la figure 10.

Avantageusement, chacune des courbes Cbg(Vgb) de la figure 11 est assimilable à une partie de la caractéristique Cbg(Vgb) obtenue pour un transistor MOS sur substrat massif.

Avantageusement, la superposition de plusieurs caractéristiques Cbg telle que celle montrée à la figure 11 permet d'obtenir une mesure de capacité assimilable à celle d'un transistor MOS sur substrat massif sur une plage étendue de valeurs de Vgb.

Le procédé de mesure MES selon l'invention comprend une quatrième étape AJU de détermination du jeu de paramètres PAR du transistor MOS sur SOI. Cette étape est réalisée à l'aide d'un ajustement entre la caractéristique Cbg(Vgb) et un modèle théorique décrivant le comportement d'un transistor de type MOS sur substrat massif.

Un tel ajustement est montré par exemple à la figure 12. Cet ajustement est limité à la plage de valeurs de Vgb pour lesquels le canal Ch du transistor est en régime de déplétion.

En effet quand le canal Ch est en régime de déplétion, la couche de semi-conducteur se comporte comme un diélectrique. Le comportement du transistor MOS sur SOI est assimilable au comportement d'un transistor MOS sur substrat massif dans lequel l'oxyde O est formé par l'empilement de l'oxyde de grille face avant DGAV, le canal semi-conducteur en régime de déplétion Ch et l'oxyde enterré DGAR.

Le modèle théorique utilisé pour l'ajustement peut donc être un modèle de transistor MOS sur substrat massif connu de l'homme du métier. Par exemple une simulation prenant en compte des effets quantiques peut être utilisée.

Par exemple, dans le cas de l'ajustement de la figure 12 les paramètres suivants sont obtenus Vfb = 0.165 V, EOT = 24.8 nm Weff = 4.47 eV.

L'EOT extrait avec le procédé MES selon l'invention est donc une estimation de l'épaisseur de l'empilement formé par la couche d'oxyde face avant DGAV d'épaisseur $T_{ox}$, la couche semi-conductrice Ch en régime de déplétion d'épaisseur $T_{ch,equiv}$ et l'oxyde enterré DGAR, d'épaisseur $T_{box}$.

Avantageusement, le procédé MES selon l'invention permet d'interpréter le comportement complexe du transistor MOS sur substrat SOI en utilisant la connaissance du comportement d'un transistor MOS sur substrat massif.

La connaissance de la tension de bande plates Vfb à la face arrière de l'oxyde enterré DGAR permet d'identifier la condition de tension appliquée pour laquelle la charge dans le substrat SUB semi-conducteur est nulle. Il est donc possible de calculer, à partir de cette condition de charge nulle la charge pour d'autres polarisations de substrats pourvu que l'on reste en déplétion.

A cette fin, le procédé MES selon l'invention comprend en outre une étape MES_Vgs de mesure des capacités Cgc et Cgb en fonction de la tension Vgs.

Cette étape du procédé MES est réalisée à l'aide des montages des figures 4c et 4d. La tension Vgs est la tension appliquée entre la grille face avant GAV et les électrodes sources S et drain D du semi-conducteur MOS sur substrat SOI. La capacité Cgc est la capacité entre la grille face avant GAV et le canal semi-conducteur Ch. La capacité Cgb est la capacité entre la grille face avant GAV et la face arrière GAR du substrat semi-conducteur SUB.

En d'autres termes, les capacités Cgc et Cgb mesurées à l'étape MES_Vgs sont les capacités mesurées de façon connue par l'homme du métier. Ces mesures sont représentées à la figure 7. Sur cette figure on peut voir que la capacité Cgb ne remonte pas aux tensions positives, à cause du fait que la présence de l'oxyde enterré DGAR empêche l'arrivée des porteurs majoritaires. Il est donc impossible d'accéder à la tension de bandes plates Vfb à partir de ces mesures.

Cependant, grâce à la tension de bandes plates Vfb à la face arrière de l'oxyde enterré DGAR, déterminée à l'étape AJU du procédé MES selon l'invention, il est possible de revenir pertinemment sur les mesures de figure 7 et de calculer pour chaque tension Vgs la charge du canal Ch d'une part et du substrat SUB d'autre part. La figure 14 montre les mesures de figure 7 et la tension de bandes plates Vfb indiquée avec un x sur la courbe Cgb.

Le procédé MES selon l'invention comprend donc une étape CHARGE de calcul de la la densité surfacique de porteurs N(Qtot) en fonction de la tension Vgs.

La densité surfacique de porteurs peut être calculée à partir de la charge en utilisant l'équation suivante Q = q N(Q) (8) avec q la charge élémentaire de l'électron

On entend ici par Qtot la charge totale qui est la somme des charges de porteurs libres et charges fixes :

$$Q_{tot} = Q_{Ch} + Q_{Well} + Q_{dop,ch} + Q_{box} + Q_{int} \quad (9)$$

Dans l'équation (9) on retrouve les contributions des charges du canal Ch, $Q_{ch}$, du substrat SUB semi-conducteur, $Q_{Well}$, des dopants du canal déplété, $Q_{dop,ch}$, des charges fixes de l'oxyde enterré DGAR, $Q_{box}$, et les charges fixes à l'interface entre l'oxyde face avant DGAV et le canal Ch, $Q_{int}$.

Cette équation peut être simplifiée en prenant en compte uniquement les charges du canal Ch et celles du substrat SUB semi-conducteur :

$$Q_{tot} = Q_{Ch} + Q_{Well} \quad (9b)$$

Ce calcul des charges dans les différentes couches semi-conductrices canal Ch et substrat SUB peut alors être réalisé à l'aide de l'équation (2). L'intégrale d'une capacité C en F/m$^2$ conduit sur le mode d'une équation du type de l'équation (2) à une charge Q en C/m$^2$.

La figure 15 montre la densité surfacique de porteurs totale N(Qtot), la densité surfacique de porteurs dans le canal Ch N(Qch) et la densité surfacique de porteurs dans le substrat semi-conducteur SUB N(QWell). Ces densités surfaciques sont obtenues à l'étape CHARGE du procédé MES selon l'invention.

La figure 16 montre la densité surfacique de porteurs N(Qtot) pour différentes polarisations de face arrière Vb. Les courbes de la figure 16 sont obtenues pour des polarisations de face arrière Vb comprises entre 6 V et -7 V.

Remarquablement, en dehors du régime de déplétion, c'est-à-dire dès que l'on a une inversion dans le canal Ch, les différentes courbes se superposent. Ce qui semble témoigner d'un comportement général du semi-conducteur. Etant donné que c'est une relation qui lie Vgs et Qtot et compte tenu de la relation entre ces deux paramètres telle qu'elle est définie en équation 4, il s'agit d'une relation entre la chute de tension dans le semi-conducteur et la charge à son interface.

Il est donc possible d'effectuer différentes simulations où on cherche à résoudre pour l'empilement Métal/oxyde/semi-conducteur/oxyde enterré/substrat le potentiel interne selon les polarisations appliquées, par exemple en couplant de manière auto consistante les équations de Poisson et de Schrödinger. Ces simulations ont été effectuées pour différents dispositifs, en cherchant à chaque fois à identifier la relation existant entre la charge totale Qtot vue depuis l'interface entre DGAV et Ch et la position relative du niveau de Fermi Ef et de la bande de conduction Ec du semi-conducteur à cette même interface où on accumule ou inverse les porteurs. Cette étude a été faite pour des capacités sur substrat SOI avec différents niveaux de dopage dans le canal Ch et des capacités sur substrat massif avec différents niveaux de dopage. Ces simulations sont représentées à la figure 17. Plus précisément les courbes de la figure 17 montrent la densité surfacique de porteurs N(Qtot) en fonction de Ef-Ec. Les différentes courbes représentent : des simulations pour des transistors MOS sur SOI pour différentes polarisation Vb de face arrière GAR et des simulations pour des transistors MOS sur substrat massif pour différents dopages du semi-conducteur.

Remarquablement, dès lors qu'on attend l'accumulation ou l'inversion de porteurs libres, on rejoint un comportement universel qui dépend seulement de la nature du semi-conducteur que l'on simule (Silicium, Germanium, GaN,...). La figure 18 montre les caractéristiques N(Qtot) en fonction de Ef-Ec qui peuvent être déduites de ces simulations pour du Silicium. Ces courbes représentent donc la relation entre la densité surfacique de porteurs N(Qtot) et la différence Ef-Ec pour un transistor MOS sur SOI. En particulier, la partie des courbes de la figure 18 signalée en gras et dont les valeurs sont rapportées dans la Figure 20 représente un comportement universel et commun à tout MOS.

Reconsidérant l'équation (3) et prenant en compte que $W_{F,M}/q = Weff$, $W_{F,S}/q - \psi_{sc} = X + (Ec-Ef)/q$ et $Vox = -q.N(Qtot)/Cox$, on arrive à la relation suivante :

$$q.Vgs + X + (Ec-Ef) = Weff - q. Qtot/Cox \quad (10) \, ,$$

dans laquelle X est l'affinité électronique du Semi-conducteur de référence que l'on prend à 4.2 eV pour le Silicium dans cette application. On s'attend donc à ce que le tracé de $q.Vgs + X + (Ec-Ef)$ en fonction de Qtot conduise à une partie linéaire dont la pente est proportionnelle à l'EOTfox, l'épaisseur effectif de l'oxyde de grille face avant DGAV, et l'ordonnée à l'origine à Weff soit le travail de sortie effectif. En effet, on a $Cox = \varepsilon0.\varepsilon Sio2/EOTfox$ dans l'équation 10 par définition.

Le procédé MES selon l'invention comprend donc une étape ENE de détermination de l'énergie $E = q Vgs + X + (Ec-Ef)$ à partir de la densité surfacique de porteurs N(Qtot). La densité surfacique des porteurs N(Qtot) est liée à la différence Ec-Ef à travers les simulations de la figure 18 et à l'énergie q Vgs à travers les courbes de la figure 15.

Avantageusement, l'étape ENE permet d'obtenir une dépendance linéaire entre l'énergie E et la densité surfacique de charge Q(Ntot) ou la densité surfacique de charges Ntot.

La Figure 19 montre ce type de tracé linéaire pour les données de la Figure 7 en utilisant la relation Qtot(Vgs) montrée à la Figure 15.

Le procédé MES selon l'invention comprend également une étape LIN d'ajustement linéaire de la quantité E en fonction du nombre de porteurs Ntot.

Avantageusement cette étape conduit directement à une estimation de Weff et EOTfox qui dans ce cas valent respectivement 4.475 eV et 2.66nm. Un ajustement linéaire permet en outre une estimation plus simple, fiable et reproductible des paramètres Weff et EOTfox.

En effet Weff est l'ordonnée à l'origine de la courbe de la figure 19 et EOTfox sa pente à un facteur près. La pente de E(Ntot) vaut $-.q^2.EOTfox/\varepsilon_{SiO2}$.

Avantageusement, l'étape LIN permet de déduire avec un ajustement très simple deux paramètres fondamentaux tels que le travail de sortie de la grille face avant Weff et l'épaisseur effectif de l'oxyde face avant EOTfox.

Avantageusement, les étapes MES_Vgs, CHARGE, CARAC et AJU permettent, sous certaines conditions d'accumulation ou d'inversion, de mettre en évidence une relation universelle pour un semi-conducteur entre le champ à son interface et la position du niveau de Fermi.

Cette relation universelle est couplée à la relation mesurée de la charge totale vue à l'interface avec la polarisation pour extraire directement le travail de sortie effectif et l'EOTfox. Cette extraction est faite à partir de l'ordonnée à l'origine et de la pente de la ligne droite ainsi obtenue. La charge totale vue à l'interface est calculée à partir de la charge de substrat SUB et de la charge de canal Ch.

Le procédé MES selon l'invention permet également de mesurer l'épaisseur équivalent $T_{box}$ de l'oxyde enterré DGAR, en exploitant les capacités mesurées Cbg et Cbc de figure 9.

Dans ce cas, l'empilement est assimilable à un empilement Semi-conducteur/Oxyde/Semi-conducteur.

A cette fin, le procédé MES comprend en outre une étape supplémentaire CHARGE_BOX de détermination de la densité surfacique de charge N(Qtot) par intégration des caractéristiques Cbg(Vbs) et Cbc(Vbs) de figure 9. Dans ce cas, Qtot est la charge vue par l'interface concernée qui est la face arrière du canal. Qtot est donc la somme de la charge du canal Ch et de la grille face avant GAV.

De façon similaire à ce qui a été réalisé lors de l'étape ENE, on peut démontrer la validité de la relation suivante entre la tension Vbs et la charge Qtot, on tient compte cette fois que l'interface arrière du canal n'est plus contrôlée par un empilement MIS (Métal/Isolant/Semi-conducteur) mais par un empilement SIS (Semi-conducteur/Isolant/Semi-con-

ducteur), le premier semi-conducteur de l'empilement SIS étant dans ce cas le substrat de la face arrière, on a donc:

$$qVbs + X1 + (Ec1\text{-}Ef1)(Qtot) = X2 + (Ec2\text{-}Ef2)(\text{-}Qtot) - q\ Qtot/Cbox\ (11)$$

On entend ici par X1 l'affinité du semi-conducteur formant le canal semi-conducteur, par (Ec1-Ef1)(Qtot) la caractéristique issue de la relation universelle identifiée en Figure 18 pour le semi-conducteur de canal, par X2 l'affinité du semi-conducteur formant le substrat semi-conducteur SUB et par (Ec2-Ef2)(-Qtot) la caractéristique complémentaire à celle retenue pour (Ec1-Ef1).

Le procédé MES comprend également une étape ENE_BOX de détermination de l'énergie Eb = qVbs + X1 + (Ec1-Ef1)(Qtot) - (Ec2-Ef2)(-Qtot) à partir de la densité surfacique de porteurs N(Qtot). La densité surfacique des porteurs N(Qtot) est liée à la différence Ec1-Ef1 à travers la loi universelle établie dans la figure 18 et à l'énergie q Vbs à travers les courbes déterminées à l'étape CHARGE_BOX. Plus précisément, on choisit pour la relation (Ec1-Ef1)(Qtot) et la relation (Ec2-Ef2)(-Qtot) la partie de la caractéristique universelle correspondant au signe des charges Qtot et -Qtot du semi-conducteur.

Avantageusement, l'énergie Eb varie linéairement en fonction de la densité de porteurs Ntot.

Lors d'une étape d'ajustement linéaire, il est possible d'extraire les paramètres X2 et $T_{box}$. En effet X2 est identifié à partir de l'ordonnée à l'origine de Eb et $C_{BOX}$ à partir de la pente de Eb. L'épaisseur équivalente d'oxyde $T_{box}$ est ensuite déterminée à partir de $C_{BOX}$, de façon connue de l'homme du métier.

Avantageusement, le procédé MES selon l'invention comprend en outre une étape de détermination de l'épaisseur équivalente du canal Ch semi-conducteur EOTsi = EOT - $EOT_{box}$ - EOTfox.

## Revendications

1. Procédé (MES) de mesure d'un jeu de paramètres (PAR) d'un transistor de type MOS sur substrat de type SOI (Silicon On Insulator), ledit jeu de paramètres (PAR) incluant au moins la tension de bandes plates (Vfb) à la face arrière de l'oxyde enterré (DGAR), ledit procédé comprenant les étapes suivantes :

   - appliquer (APP) à la face arrière du substrat du transistor une tension principale continue Vbs et une tension alternative v(t), la tension principale continue Vbs pouvant balayer une plage de valeurs (DV) prédéterminée ;
   - mesurer (MIG) le courant électrique Ig(t) issu de la grille face avant et déterminer à partir de cette mesure la capacité Cbg entre la face arrière du substrat du transistor et la grille face avant, de façon à obtenir la caractéristique Cbg(Vbs) ;
   - à partir de la caractéristique Cbg(Vbs) déterminer (CARAC) la caractéristique Cbg(Vgb), Vgb étant la tension entre la grille face avant et la grille face arrière ;
   - déterminer (AJU) le jeu de paramètres (PAR) en réalisant un ajustement entre la caractéristique Cbg(Vgb) et un modèle théorique décrivant le comportement d'un transistor de type MOS sur substrat massif, ledit ajustement étant limité à la plage de valeurs de Vgb pour lesquels le canal du transistor est en régime de déplétion.

2. Procédé (MES) selon la revendication précédente **caractérisé en ce que** le jeu de paramètres (PAR) comprend, en plus de la tension de bandes plates (Vfb) à la face arrière de l'oxyde enterré, au moins l'un des paramètres suivants :

   - l'épaisseur équivalente d'oxyde (EOT) ;
   - le travail de sortie effectif du métal de grille (Weff).

3. Procédé (MES) selon la revendication précédente **caractérisé en ce que** l'épaisseur équivalent d'oxyde (EOT) correspond à l'épaisseur cumulée des couches d'oxyde, de canal et d'oxyde enterré.

4. Procédé (MES) selon l'une des revendications précédentes **caractérisé en ce que** la caractéristique Cbg(Vbg) est reconstruite à partir de plusieurs mesures de Cbg, chaque mesure étant obtenue pour une tension de grille face avant Vg différente.

5. Procédé (MES) selon l'une des revendications précédentes **caractérisé en ce qu'**il comprend en outre les étapes suivantes :

   - à partir d'une mesure de type C(Vgs) déterminer (MES_Vgs) les caractéristiques Cgc(Vgs) et Cgb(Vgs), Vgs étant la tension appliquée entre la grille face avant (GAV) et les électrodes source (S) et drain (D) du transistor MOS sur substrat SOI ;

- à partir de la valeur de la tension de bandes plates (Vfb) déterminée à l'étape d'ajustement (AJU) et des caractéristiques Cgb(Vgs) et Cgc(Vgs), calculer (CHARGE) la densité surfacique de porteurs N(Qtot) en fonction de la tension Vgs ;

- à partir de la densité surfacique de porteurs N(Qtot), déterminer (ENE) l'énergie E, définie par la relation E= qVgs + X + (Ec-Ef), en fonction du nombre de porteurs Ntot, q étant la charge de l'électron, X l'affinité électronique du semiconducteur du canal (Ch), Ef le niveau de Fermi du semi-conducteur de canal (Ch), Ec l'énergie de la bande de conduction du semi-conducteur du canal (Ch) à son interface avec l'oxyde de grille face avant (DGAV) ;

- obtenir à l'aide d'un ajustement linéaire (LIN) de E en fonction du nombre de porteurs le travail de sortie effectif (Weff) de la grille avant et l'épaisseur (EOTfox) effectif de l'oxyde de grille face avant (DGAV).

6. Procédé (MES) selon la revendication précédente **caractérisé en ce que** le travail effectif de sortie (Weff) est l'ordonnée à l'origine de la fonction E(Ntot) et l'épaisseur effective de l'oxyde de grille avant (EOTfox) est obtenue à partir de la pente de la fonction E(Ntot).

7. Procédé (MES) selon la revendication 5 ou la revendication 6 comprenant en outre une étape de détermination de l'épaisseur de l'oxyde enterré.

8. Procédé (MES) selon l'une des revendications précédentes **caractérisé en ce qu'**il comprend en outre les étapes suivantes :

- à partir de la valeur de la tension de bandes plates (Vfb) déterminée à l'étape d'ajustement (AJU) et des caractéristiques Cbc(Vbs) et Cbg(Vbs), calculer (CHARGE_BOX) la densité surfacique de porteurs N(Qtot) en fonction de la tension Vbs ;

- à partir de la densité surfacique de porteurs N(Qtot) déterminée à l'étape précédente, déterminer (ENE_BOX) l'énergie Eb, définie par la relation Eb= qVbs + X1 + (Ec1-Ef1)(Qtot) - (Ec2-Ef2) (-Qtot), en fonction du nombre de porteurs Ntot, q étant la charge de l'électron, X1 l'affinité électronique du canal semi-conducteur (Ch), Ef1 le niveau de Fermi du semiconducteur du canal connecté par source et drain, Ec1 l'énergie de la bande de conduction du semi-conducteur du canal (Ch) à l'interface canal (Ch)/oxyde enterré (DGAR), Ef2 le niveau de Fermi du semiconducteur du substrat (SUB) connecté par la prise GAR, Ec2 l'énergie de la bande de conduction du semi-conducteur du substrat (SUB) à l'interface arrière de l'oxyde enterré;

- obtenir à l'aide d'un ajustement linéaire (LIN_BOX) de Eb en fonction du nombre de porteurs l'affinité électrique du substrat semi-conducteur (X2) et l'épaisseur (EOT$_{box}$) effectif de l'oxyde enterré (DGAR).

9. Procédé selon les revendications 3, 6 et 8 comprenant en outre une étape de calcul de l'épaisseur efficace du canal semi-conducteur EOTsi, l'épaisseur efficace du canal semi-conducteur étant calculé comme EOTsi = EOT - EOT$_{FOX}$ -EOT$_{BOX}$.

## Patentansprüche

1. Messverfahren (MES) eines Parametersatzes (PAR) eines Transistors vom Typ MOS auf Substrat vom Typ SOI (Silicon On Insulator), wobei der genannte Parametersatz (PAR) wenigstens die Spannung von Flachbändern (Vfb) an der Rückseite des verdeckten Oxids (DGAR) enthält, wobei das genannte Verfahren die folgenden Schritte umfasst:

- Anwenden (APP) einer kontinuierlichen Hauptspannung Vbs und einer alternativen Spannung v(t) auf die Rückseite des Substrats des Transistors, wobei die kontinuierliche Hauptspannung Vbs einen vorbestimmten Wertebereich (DV) abtasten kann;

- Messen (MIG) des aus dem Gitter der Vorderseite stammenden elektrischen Stroms Ig(t) und ausgehend von dieser Messung Bestimmen der Kapazität Cbg zwischen der Rückseite des Substrats des Transistors und dem Gitter der Vorderseite derart, dass das Merkmal Cbg(Vbs) erhalten wird;

- ausgehend von dem Merkmal Cbg(Vbs) Bestimmen (CARAC) des Merkmals Cbg(Vgb), wobei Vgb die Spannung zwischen dem Gitter der Vorderseite und dem Gitter der Rückseite ist;

- Bestimmen (AJU) des Parametersatzes (PAR) per Durchführen einer Anpassung zwischen dem Merkmal Cbg(Vgb) und einem theoretischen Modell, das das Verhalten eines Transistors vom Typ MOS auf massivem Substrat beschreibt, wobei die genannte Anpassung auf den Wertebereich von Vgb beschränkt ist, für die der Kanal des Transistors im Verarmungsbetrieb ist.

2.  Verfahren (MES) gemäß dem voranstehenden Anspruch, **dadurch gekennzeichnet, dass** der Parametersatz (PAR) zusätzlich zu der Spannung von Flachbändern (Vfb) an der Rückseite des verdeckten Oxids wenigstens einen der folgenden Parameter umfasst:

    - die äquivalente Oxiddicke (EOT);
    - die effektive Ausgangsarbeit des Gittermetalls (Weff).

3.  Verfahren (MES) gemäß dem voranstehenden Anspruch, **dadurch gekennzeichnet, dass** die äquivalente Oxiddicke (EOT) der kumulierten Dicke der Oxid-, Kanal- und verdeckten Oxidschichten entspricht.

4.  Verfahren (MES) gemäß einem der voranstehenden Ansprüche, **dadurch gekennzeichnet, dass** das Merkmal Cbg(Vbg) ausgehend von mehreren Messungen von Cbg wieder aufgebaut wird, wobei jede Messung für eine unterschiedliche Gitterspannung der Vorderseite Vg erhalten wird.

5.  Verfahren (MES) gemäß einem der voranstehenden Ansprüche, **dadurch gekennzeichnet, dass** es darüber hinaus die folgenden Schritte umfasst:

    - ausgehend von einer Messung vom Typ C(Vgs) Bestimmen (MES_Vgs) der Merkmale Cgc(Vgs) und Cgb(Vgs), wobei Vgs die angewendete Spannung zwischen dem Gitter der Vorderseite (GAV) und den Source-(S) und Drain- (D)-Elektroden des Transistors MOS auf dem Substrat SOI sind;
    - ausgehend von dem Wert der Spannung von Flachbändern (Vfb), die im Anpassungsschritt (AJU) bestimmt wird, und den Merkmalen Cgb(Vgs) und Cgc(Vgs), Berechnen (CHARGE) der Oberflächendichte von Trägern N(Qtot) in Abhängigkeit von der Spannung Vgs;
    - ausgehend von der Oberflächendichte von Trägern N(Qtot) Bestimmen (ENE) der Energie E, die durch die Relation E = qVgs + X + (Ec-Ef) definiert wird, in Abhängigkeit von der Anzahl von Trägern Ntot, wobei q die Ladung des Elektrons, X die elektronische Affinität des Halbleiters des Kanals (Ch), Ef das Fermi-Niveau des Halbleiterkanals (Ch), Ec die Energie des Leitungsbandes des Halbleiters des Kanals (Ch) an seiner Schnittstelle mit dem Gitteroxid der Vorderseite (DGAV) ist;
    - mithilfe einer linearen Anpassung (LIN) von E in Abhängigkeit von der Anzahl von Trägern Erhalten der effektiven Ausgangsarbeit (Weff) des vorderen Gitters und der effektiven Dicke (EOTfox) des Gitteroxids der Vorderseite (DGAV).

6.  Verfahren (MES) gemäß dem voranstehenden Anspruch, **dadurch gekennzeichnet, dass** die effektive Ausgangsarbeit (Weff) die Ordinate ist, auf die die Funktion E(Ntot) zurückzuführen ist, und die effektive Dicke des vorderen Gitteroxids (EOTfox) ausgehend von der Neigung der Funktion E(Ntot) erhalten wird.

7.  Verfahren (MES) gemäß Anspruch 5 oder Anspruch 6, umfassend darüber hinaus einen Bestimmungsschritt der Dicke des verdeckten Oxids.

8.  Verfahren (MES) gemäß einem der voranstehenden Ansprüche, **dadurch gekennzeichnet, dass** es darüber hinaus die folgenden Schritte umfasst:

    - ausgehend von dem Wert der Spannung von Flachbändern (Vfb), der im Anpassungsschritt (AJU) bestimmt wird, und der Merkmale Cbc(Vbc) und Cbg(Vbs) Berechnen (CHARGE_BOX) der Oberflächendichte von Trägern N(Qtot) in Abhängigkeit von der Spannung Vbs;
    - ausgehend von der Oberflächendichte von Trägern (N(Qtot), die im voranstehenden Schritt bestimmt wird, Bestimmen (ENE_BOX) der Energie Eb, die durch die Relation Eb = qVbs + X1 + (Ec1-Ef1) (Qtot) - (Ec2-Ef2) (-Qtot) definiert wird, in Abhängigkeit von der Anzahl von Trägern Ntot, wobei q die Last des Elektrons, X1 die elektronische Affinität des Halbleiter-Kanals (Ch), Ef1 das Fermi-Niveau des Halbleiters des per Source und Drain angeschlossenen Kanals, EC1 die Energie des Leitungsbandes des Halbleiters des Kanals (Ch) an der Schnittstelle Kanal (Ch)/verdecktes Oxid (DGAR), Ef2 das Fermi-Niveau des Halbleiters des Substrats (SUB), das durch den Anschluss GAR angeschlossen ist, Ec2 die Energie des Leitungsbandes des Halbleiters des Substrats (SUB) an der hinteren Schnittstelle des verdeckten Oxids ist;
    - mithilfe einer linearen Anpassung (LIN_BOX) von Eb in Abhängigkeit von der Anzahl von Trägern Erhalten der elektrischen Affinität des Halbleitersubstrats (X2) und der effektiven Dicke (EOT$_{box}$) des verdeckten Oxids (DGAR).

9. Verfahren gemäß der Ansprüche 3, 6 und 8, umfassend darüber hinaus einen Berechnungsschritt der effizienten Dicke des Halbleiterkanals EOTsi, wobei die effektive Dicke des Halbleiterkanals als EOTsi = EOT - $EOT_{FOX}$ - $EOT_{BOX}$ berechnet wird.

**Claims**

1. A method (MES) for measuring a set of parameters (PAR) of a MOS type transistor on SOI (Silicon On Insulator) type substrate, said set of parameters (PAR) including at least the flat band voltage (Vfb) at the rear face of the buried oxide (DGAR), said method comprising the following steps of:

   - applying (APP) a main direct voltage Vbs and an alternating voltage v(t) to the rear face of the substrate of the transistor, the main direct voltage Vbs being able to cover a predetermined value range (DV);
   - measuring (MIG) the electric current Ig(t) from the front face gate and determining the capacitance Cbg between the rear face of the substrate of the transistor and the front face gate from this measurement, so as to obtain the characteristic Cbg(Vbs);
   - from the characteristic Cbg(Vbs) determining (CARAC) the characteristic Cbg(Vgb), Vgb being the voltage between the front face gate and the rear face gate;
   - determining (AJU) the set of parameters (PAR) by making adjustment between the characteristic Cbg(Vgb) and a theoretical model describing the behaviour of an MOS type transistor on bulk substrate, said adjustment being limited to the range of Vgb values for which the channel of the transistor is in depletion mode.

2. The method (MES) according to the previous claim, **characterised in that** the set of parameters (PAR) comprises, in addition to the flat band voltage (Vfb) at the rear face of the buried oxide, at least one of the following parameters:

   - the equivalent oxide thickness (EOT);
   - the effective output work of the gate metal (Weff).

3. The method (MES) according to the previous claim, **characterised in that** the equivalent oxide thickness (EOT) corresponds to the cumulative thickness of the oxide, channel and buried oxide layers.

4. The method (MES) according to one of the previous claims, **characterised in that** the characteristic Cbg(Vbg) is reconstructed from several measurements of Cbg, each measurement being obtained by a different front face gate voltage Vg.

5. The method (MES) according to one of the previous claims, **characterised in that** it further comprises the following steps of:

   - from a C(Vgs) type measurement, determining (MES_Vgs), the characteristics Cgc(Vgs) and Cgb(Vgs), Vgs being the voltage applied between the front face gate (GAV) and the source (S) and drain (D) electrodes of the MOS transistor on SOI substrate;
   - from the value of the flat band voltage (Vfb) determined in the adjustment step (AJU) and from the characteristics Cgb(Vgs) and Cgc(Vgs), calculating (CHARGE) the carrier surface density N(Qtot) as a function of the voltage Vgs;
   - from the carrier surface density N(Qtot), determining (ENE) the energy E, defined by the relationship E = qVgs + X + (Ec - Ef), as a function of the number of carriers Ntot, q being the electron charge, X the electron affinity of the semiconductor of the channel (Ch), Ef the Fermi level of the semiconductor of the channel (Ch), Ec the energy of the conduction band of the semiconductor of the channel (Ch) at its interface with the front face gate oxide (DGAV);
   - obtaining the effective output work (Weff) of the front gate and the effective thickness (EOTfox) of the front face gate oxide (DGAV), using a linear adjustment (LIN) of E as a function of the number of carriers.

6. The method (MES) according to the previous claim, **characterised in that** the effective output work (Weff) is the ordinate at the origin of the function E(Ntot) and the effective thickness of the front gate oxide (EOTfox) is obtained from the slope of the function E(Ntot).

7. The method (MES) according to claim 5 or claim 6, further comprising a step of determining a thickness of the buried oxide.

8. The method (MES) according to one of the previous claims, **characterised in that** it further comprises the following steps of:

- from the value of the flat band voltage (Vfb) determined in the adjustment step (AJU) and from the characteristics Cbc(Vbs) and Cbg(Vbs), calculating (CHARGE_BOX) the carrier surface density N(Qtot) as a function of the voltage Vbs;
- from the carrier surface density N(Qtot) determined in the previous step, determining (ENE_BOX) the energy Eb, defined by the relationship Eb = qVbs + X1 + (Ec1 - Ef1 )(Qtot) - (Ec2 - Ef2)(- Qtot), as a function of the number of carriers Ntot, q being the electron charge, X1 the electron affinity of the semiconductor channel (Ch), Ef1 the Fermi level of the semiconductor of the source and drain-connected channel, Ec1 the energy of the conduction band of the semiconductor of the channel (Ch) at the channel (Ch)/buried oxide interface (DGAR), Ef2 the Fermi level of the semiconductor of the substrate (SUB) connected by the tap GAR, Ec2 the energy of the conduction band of the semiconductor of the substrate (SUB) at the rear interface of the buried oxide;
- obtaining the electric affinity of the semiconductor substrate (X2) and the effective thickness ($EOT_{box}$) of the buried oxide (DGAR) using a linear adjustment (LIN_BOX) of Eb as a function of the number of carriers.

9. The method according to claims 3, 6 and 8 further comprising a step of calculating the effective thickness of the semiconductor channel EOTsi, the effective thickness of the semiconductor channel being calculated as

$$EOT_{Si} = EOT - EOT_{FOX} - EOT_{Box.}$$

**Fig. 1a**

**Fig. 1b**

**Fig. 2A**

**Fig. 2b**

**Fig. 3a**

**Fig. 3b**

**Fig. 4a**

Vg

GAV

DGAV

Ch

DGAR

SUB

GAR

Vb

**Fig. 4b**

S

GAV

D

GAR

DGAV

M

O

ISOLANT  P+  Film silicium  P+  ISOLANT  N+

Oxyde enterré

Substrat N

SUB

DGAR  Ch

Fig. 4c

Fig. 4d

Fig. 5a

Fig. 5b

**Fig. 6**

**Fig. 7**

**Fig. 7a**

**Fig. 7b**

**Fig. 8a**

**Fig. 8b**

Fig. 9

Fig. 10

Fig. 11

**Fig. 12**

**Fig. 13**

Fig. 14

Fig. 15

Fig. 16

Fig. 17

Fig. 18

Fig. 19

| Ef-Ec [eV] | N(Qtot)PMOS_Si | Ef-Ec [eV] | N(Qtot)NMOS_Si |
|---|---|---|---|
| -1,49 | 1,75E+17 | -0,03 | -3,17E+15 |
| -1,48 | 1,67E+17 | -0,01 | -8,82E+15 |
| -1,46 | 1,59E+17 | 0,02 | -1,47E+16 |
| -1,45 | 1,51E+17 | 0,04 | -2,09E+16 |
| -1,44 | 1,43E+17 | 0,06 | -2,73E+16 |
| -1,42 | 1,35E+17 | 0,08 | -3,39E+16 |
| -1,41 | 1,27E+17 | 0,10 | -4,08E+16 |
| -1,40 | 1,19E+17 | 0,11 | -4,78E+16 |
| -1,38 | 1,11E+17 | 0,13 | -5,49E+16 |
| -1,37 | 1,04E+17 | 0,15 | -6,22E+16 |
| -1,35 | 9,62E+16 | 0,16 | -6,96E+16 |
| -1,34 | 8,87E+16 | 0,18 | -7,72E+16 |
| -1,32 | 8,13E+16 | 0,19 | -8,48E+16 |
| -1,31 | 7,40E+16 | 0,21 | -9,25E+16 |
| -1,29 | 6,68E+16 | 0,22 | -1,00E+17 |
| -1,27 | 5,97E+16 | 0,24 | -1,08E+17 |
| -1,25 | 5,27E+16 | 0,25 | -1,16E+17 |
| -1,24 | 4,59E+16 | 0,26 | -1,24E+17 |
| -1,22 | 3,92E+16 | 0,27 | -1,32E+17 |
| -1,20 | 3,27E+16 | 0,29 | -1,40E+17 |
| -1,18 | 2,64E+16 | 0,30 | -1,49E+17 |
| -1,15 | 2,02E+16 | | |
| -1,13 | 1,43E+16 | | |
| -1,11 | 8,56E+15 | | |
| -1,08 | 3,03E+15 | | |

# Fig. 20

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **C. LEROUX et al.** Accurate détermination of flat band voltage in advanced MOS structures. *Microelectronics Reliability,* 2007, vol. 47, 660-664

- **M. MOHAMAD.** *Reliable Gate Stack and Substrate Parameter Extraction based on C-V measurements for 14 nm node FDSOI technology*